# EUROPÄISCHE PATENTSCHRIFT

(11) **EP 3 818 414 B1**
(45) Veröffentlichungstag und Bekanntmachung des Hinweises auf die Patenterteilung: **31.08.2022**
(21) Anmeldenummer: 19734740.4
(22) Anmeldetag: 25.06.2019
(51) Int. Cl.: G03F 7/20, G02B 7/182, G02B 7/183

(54) **ABSTÜTZUNG EINER OPTISCHEN EINHEIT**
SUPPORT OF AN OPTICAL UNIT
SYSTÈME DE SOUTIEN D'UN ENSEMBLE OPTIQUE

(30) Priorität: 04.07.2018 DE 102018210996
(43) Veröffentlichungstag der Anmeldung: 12.05.2021
(73) Patentinhaber: Carl Zeiss SMT GmbH, 73447 Oberkochen (DE)
(72) Erfinder: VOGT, Martin, 73557 Mutlangen (DE); HARTJES, Joachim, 73433 Aalen (DE)
(74) Vertreter: Cohausz & Florack
(86) Internationale Anmeldenummer: PCT/EP2019/066818
(87) Internationale Veröffentlichungsnummer: WO 2020/007649

(56) Entgegenhaltungen:
- EP-A1- 1 143 492
- US-A1- 2009 091 733
- US-A1- 2011 043 781

## Beschreibung

### HINTERGRUND DER ERFINDUNG

Die vorliegende Erfindung betrifft eine Anordnung für die Mikrolithographie mit einer Stützstruktur zum Abstützen einer optischen Einheit, die für die Verwendung von UV Nutzlicht geeignet ist, insbesondere von Licht im extremen ultravioletten (EUV) Bereich. Weiterhin betrifft die Erfindung eine optische Abbildungseinrichtung mit einer solchen Anordnung, ein entsprechendes Verfahren zum Abstützen einer optischen Einrichtung sowie ein entsprechendes optisches Abbildungsverfahren. Die Erfindung lässt sich im Zusammenhang mit beliebigen optischen Abbildungsverfahren einsetzen. Besonders vorteilhaft lässt sie sich bei der Herstellung oder der Inspektion mikroelektronischer Schaltkreise sowie der hierfür verwendeten optischen Komponenten (beispielsweise optischer Masken) einsetzen.

Die im Zusammenhang mit der Herstellung mikroelektronischer Schaltkreise verwendeten optischen Einrichtungen umfassten typischerweise eine Mehrzahl optischer Elementeinheiten, die ein oder mehrere optische Elemente wie Linsen, Spiegel oder optische Gitter umfassen, die im Abbildungslichtpfad angeordnet sind. Diese optischen Elemente wirken typischerweise in einem Abbildungsprozess zusammen, um ein Bild eines Objekts (beispielsweise ein auf einer Maske gebildetes Muster) auf ein Substrat (beispielsweise einen so genannten Wafer) zu transferieren. Die optischen Elemente sind typischerweise in einer oder mehreren funktionalen Gruppen zusammengefasst, die gegebenenfalls in separaten Abbildungseinheiten gehalten sind. Insbesondere bei hauptsächlich refraktiven Systemen, die mit einer Wellenlänge im so genannten Vakuum-Ultraviolett-Bereich (VUV, beispielsweise bei einer Wellenlänge von 193 nm) arbeiten, sind solche Abbildungseinheiten häufig aus einen Stapel optischer Module gebildet, die ein oder mehrere optische Elemente halten. Diese optischen Module umfassen typischerweise eine Stützstruktur mit einer im Wesentlichen ringförmigen äußeren Stützeinheit, die einen oder mehrere optische Elementhalter abstützt, die ihrerseits das optische Element halten.

Die immer weiter voranschreitende Miniaturisierung von Halbleiterbauelementen führt zu einem ständigen Bedarf an erhöhter Auflösung der ihre Herstellung verwendeten optischen Systeme. Dieser Bedarf an erhöhter Auflösung bedingt den Bedarf an einer erhöhten numerischen Apertur (NA) und einer erhöhten Abbildungsgenauigkeit der optischen Systeme.

Ein Ansatz, um eine erhöhte optische Auflösung zu erhalten, besteht darin, die Wellenlänge des in dem Abbildungsprozess verwendeten Lichtes zu verringern. In den vergangenen Jahren wurde verstärkt die Entwicklung von Systemen vorangetrieben, bei denen Licht im so genannten extremen Ultraviolettbereich (EUV) verwendet wird, typischerweise bei Wellenlängen von 5 nm bis 20 nm, in den meisten Fällen bei einer Wellenlänge von etwa 13 nm. In diesem EUV-Bereich ist es nicht mehr möglich, herkömmliche refraktive optische Systeme zu verwenden. Dies ist dadurch bedingt, dass die für refraktive optische Systeme verwendeten Materialien in diesem EUV-Bereich einen Absorptionsgrad aufweisen, der zu hoch ist um mit der verfügbaren Lichtleistung akzeptable Abbildungsergebnisse zu erzielen. Folglich müssen in diesem EUV-Bereich reflektive optische Systeme für die Abbildung verwendet werden.

Dieser Übergang zu rein reflektiven optischen Systemen mit hoher numerischer Apertur (z. B. NA > 0,4 bis 0,5) im EUV-Bereich führt zu erheblichen Herausforderungen im Hinblick auf das Design der Abbildungseinrichtung.

Eine der zentralen Genauigkeitsanforderungen ist die Genauigkeit der Position der Abbildung auf dem Substrat, die häufig auch als so genannte Line-of-Sight-Genauigkeit (LoS-Genauigkeit) bezeichnet wird. Die Line-of-Sight-Genauigkeit skaliert typischerweise etwa mit dem Inversen der numerischen Apertur. Folglich ist die Line-of-Sight-Genauigkeit bei einer Abbildungseinrichtung mit einer numerischen Apertur von NA = 0,45 um einen Faktor 1,4 kleiner als bei einer Abbildungseinrichtung mit einer numerischen Apertur von NA = 0.33. Bei einer numerischen Apertur von NA = 0,45 liegt die Line-of-Sight-Genauigkeit typischerweise unterhalb von 0.5 nm. Soll der Abbildungsprozess eine so genannte Doppelstrukturierung (typischerweise als Double Patterning bezeichnet) ermöglichen, muss die Line-of-Sight-Genauigkeit typischerweise um einen weiteren Faktor von 1,4 erhöht werden. Folglich liegt die Line-of-Sight-Genauigkeit dann sogar unterhalb von 0,3 nm.

Die oben genannten Faktoren führen zu sehr strengen Anforderungen hinsichtlich der Position und/oder Orientierung der optischen Elemente, die an der Abbildung teilnehmen, relativ zueinander sowie hinsichtlich der Deformation der einzelnen optischen Elemente, um eine gewünschte Abbildungsgenauigkeit erzielen. Zudem ist es erforderlich, diese hohe Abbildungsgenauigkeit über den gesamten Betrieb, letztlich über die Lebensdauer des Systems aufrechtzuerhalten.

Als Konsequenz müssen die Komponenten der optischen Abbildungseinrichtung (also beispielsweise die optischen Elemente der Beleuchtungseinrichtung, die Maske, die optischen Elemente der Projektionseinrichtung und das Substrat), die bei der Abbildung zusammenwirken, in einer wohldefinierten Weise abgestützt werden, um eine vorgegebene wohldefinierte räumliche Beziehung zwischen diesen Komponenten einzuhalten und eine minimale unerwünschte Deformation dieser Komponenten zu erzielen, um letztlich eine möglichst hohe Abbildungsqualität zu erreichen.

Insbesondere bei den oben genannten EUV-Systemen ergibt sich dabei das Problem, dass es sich bei der Beleuchtungseinrichtung und der Projektionseinrichtung systembedingt um vergleichsweise große und schwere optische Einheiten handelt, die bei neueren Systemen gegebenenfalls eine Masse von 6 t bis 8 t erreichen können. Diese schweren Einheiten sollen jedoch zur Einhaltung der Genauigkeitsanforderungen justierbar sein und zudem nicht schon durch die Gestaltung ihrer Lagerung unerwünschte bzw. nicht genau definierte Deformationen erfahren. Aus diesen Gründen wird zur Lagerung dieser optischen Einheiten typischerweise auf eine so genannte Dreipunktlagerung zurückgegriffen, wie sie beispielsweise auch aus der WO 2013/017171 A1 bekannt ist.

Mit einer solchen Dreipunktlagerung kann eine statisch bestimmte Lagerung erzielt bzw. eine statisch überbestimmte Lagerung vermieden werden, bei der es andernfalls aufgrund von Fertigungsungenauigkeiten bzw. von Deformationen (die durch mechanische Störungen wie Schwingungen bedingt sein können) zu unerwünschten parasitären Spannungen und daraus resultierenden Deformationen in der optischen Einheit kommen könnte.

Da das schwere optische System zudem justierbar sein soll, um die geforderte Präzision zu erzielen, kommen für die Dreipunktlagerung typischerweise so genannte Luftlager zum Einsatz, bei denen über Druckluft (oder ein anderes geeignetes Gas) ein Luftspalt zwischen den Lagerflächen aufgebaut wird. Bei diesen Luftlagern besteht jedoch das Problem, dass sie bei Einhaltung der übrigen Randbedingungen (insbesondere der dynamischen Randbedingungen) solcher EUV-Systeme in ihrer Belastbarkeit limitiert sind. Diese Belastbarkeitsgrenze ist bei optischen Einheiten zukünftiger EUV-Systeme, deren Masse 6 t bis 8 t erreichen kann, überschritten.

Aus der US2009091733 A1 ist eine Vierpunktlagerung einer Projektionseinrichtung einer mikrolithographischen Abbildungseinrichtung bekannt.

### KURZE ZUSAMMENFASSUNG DER ERFINDUNG

Der Erfindung liegt daher die Aufgabe zugrunde, eine Anordnung für die Mikrolithographie mit einer Stützstruktur zum Abstützen einer optischen Einheit, eine entsprechende optische Abbildungseinrichtung mit einer solchen Anordnung, ein entsprechendes Verfahren zum Abstützen einer optischen Einrichtung sowie ein entsprechendes optisches Abbildungsverfahren zur Verfügung zu stellen, welche bzw. welches die zuvor genannten Nachteile nicht oder zumindest in geringerem Maße aufweist und insbesondere auf einfache Weise eine Abstützung der optischen Einheit mit möglichst geringen parasitären Spannungen bzw. Deformationen zu erzielen.

Der Erfindung liegt die technische Lehre zugrunde, dass man bei der Abstützung einer solchen schweren optischen Einheit der eingangs genannten Art über Luftlager auf einfache Weise die Einleitung parasitärer Spannungen bzw. Deformationen so weit wie möglich vermeiden kann, wenn man eine Abstützung über mindestens vier separate Stützeinheiten vorsieht, von denen zwei derart zu einem Stützeinheitenpaar gekoppelt sind, dass einer Abweichung von einem vorgebbaren Verhältnis ihrer Stützkräfte entgegengewirkt wird. Die vierte (und gegebenenfalls jede weitere) Stützeinheit reduziert dabei in einfacher Weise zum einen die Last je Luftlager und ermöglicht somit deren Einsatz auch bei derart schweren optischen Einheiten. Zudem sorgt die Kopplung der beiden Stützeinheiten des Stützeinheitenpaars in einfacher Weise dafür, dass Abweichungen in Position und/oder Ausrichtung an den beiden Stützstellen von ihrem Soll-Zustand in einfacher Weise ausgeglichen werden und damit stets das Soll-Verhältnis der beiden Stützkräfte des Stützeinheitenpaars vorliegt. Solche Abweichungen können durch Fertigungsungenauigkeiten bedingt sein, sich aber auch erst im Betrieb durch störungsbedingte Deformationen ergeben.

Mit der vorliegenden Kopplung der Stützeinheiten wird mit anderen Worten eine Master-Slave-Konfiguration erreicht, bei der das Ungleichgewicht der beiden Stützkräfte (d. h. ihre Abweichung von ihrem Soll-Verhältnis) durch eine über die Kopplungseinrichtung vermittelte Ausgleichsbewegung an den beiden Stützstellen ausgeglichen wird und somit das

Gleichgewicht der beiden Stützkräfte (mithin also ihr Soll-Verhältnis) hergestellt wird.

Letztlich kann im Optimalfall hierdurch erreicht werden, dass sich das Stützeinheitenpaar im Ergebnis wie eine einzige Stützeinheit verhält und somit letztlich wiederum eine Dreipunktlagerung realisiert ist, über die eine statische bestimmte Abstützung erzielt werden kann.

Die Kopplung und die hierüber im Bedarfsfall bedingte Ausgleichsbewegung an den beiden Stützeinheiten des Stützeinheitenpaares kann dabei auf verschiedenste Weise realisiert werden. So ist eine rein passive Kopplung ebenso möglich wie eine aktiv durch eine Steuereinrichtung gesteuerte Kopplung.

Das Verhältnis der beiden Stützkräfte des Stützeinheitenpaars kann grundsätzlich beliebig geeignet gewählt sein. Limitierend ist hier lediglich die Maximalkraft Fₘₐₓ, die mittels jeder der Stützeinheiten bzw. ihres Luftlagers aufgenommen werden kann. Mithin muss also die Entlastung durch die (gegenüber einer herkömmlichen Dreipunktlagerung mit drei Stützeinheiten) zusätzliche vierte Stützeinheit so groß sein, dass diese Maximalkraft Fₘₐₓ an den übrigen Stützeinheiten (in allen erforderlichen Betriebszuständen) unterschritten wird. Gegebenenfalls sind dabei auch dynamische Zustände zu berücksichtigen, da Luftlager häufig auch Einschränkungen hinsichtlich des Verhältnisses der maximalen zur minimalen Lagerkraft im Betrieb unterliegen.

Es versteht sich, dass die Erfindung grundsätzlich im Zusammenhang mit beliebigen optischen Einheiten zur Anwendung kommen kann. Insbesondere können ihre Vorteile auch bei Konfigurationen mit deutlich leichteren optischen Einheiten zum Tragen kommen. Besonders vorteilhaft kommt sie jedoch bei Gestaltungen zur Anwendung, bei denen die Masse der optischen Einheit mehr als 4 t, vorzugsweise mehr als 6 t, weiter vorzugsweise mehr als 8 t, beträgt. Vorzugsweise kommt sie bei Gestaltungen zum Einsatz, bei denen die Masse der optischen Einheit 4 t bis 14 t, vorzugsweise 5 t bis 10 t, weiter vorzugsweise 6 t bis 8 t, beträgt.

Nach einem Aspekt betrifft die Erfindung daher eine Anordnung für die Mikrolithographie, insbesondere unter Verwendung von Licht im extremen UV-Bereich (EUV), mit einer Stützstruktur zum Abstützen einer optischen Einheit, deren Masse insbesondere 4 t bis 14 t, vorzugsweise 5 t bis 10 t, weiter vorzugsweise 6 t bis 8 t, beträgt. Die Stützstruktur umfasst eine Anzahl von separaten Stützeinheiten zum Abstützen der optischen Einheit. Jede der Stützeinheiten umfasst ein Luftlager, über welches eine Stützkraft erzeugbar ist, welche der Gewichtskraft der optischen Einheit entgegenwirkt. Die Anzahl der Stützeinheiten beträgt wenigstens vier, wobei wenigstens zwei der Stützeinheiten derart über eine Kopplungseinrichtung zu einem Stützeinheitenpaar gekoppelt sind, dass die Kopplungseinrichtung einer Abweichung von einem vorgebbaren Verhältnis der Stützkräfte der beiden Stützeinheiten des Stützeinheitenpaars entgegenwirkt.

Das Verhältnis der beiden Stützkräfte der Stützeinheiten kann grundsätzlich die beliebig gewählt sein und an die geometrischen Bedingungen und die Massenverteilung (mithin also auch die Lage des Schwerpunkts) der optischen Einheit angepasst sein. Dabei können insbesondere auch die dynamischen Bedingungen während des Betriebs der Anordnung Berücksichtigung finden. So kann es zwar unter statischen Bedingungen typischerweise von Vorteil sein, wenn das Verhältnis der Stützkräfte bei 1 liegt, da dann eine möglichst gleichmäßige Verteilung der Lasten erzielt wird. Erfährt aber eine der Stützeinheiten unter dynamischen Bedingungen (beispielsweise durch Schwingungsanregung) stark erhöhte Stützkraft, so kann es sinnvoll sein, diese unter statischen Bedingungen zu reduzieren, um den dynamischen Maximalbetrag zu reduzieren (und natürlich unter der Maximalkraft Fₘₐₓ zu halten).

Bei bestimmten vorteilhaften Varianten beträgt das vorgebbare Verhältnis V der Stützkräfte 1/3 (bzw. ca. 0,33) bis 1/1 (bzw. 1), vorzugsweise 1/2 (bzw. 0,5) bis 1/1 (bzw. 1), weiter vorzugsweise 2/3 (bzw. ca. 0,66) bis 1/1 (bzw. 1), weiter vorzugsweise 3/4 (bzw. 0,75) bis 1/1 (bzw. 1), weiter vorzugsweise 4/5 (bzw. 0,8) bis 1/1 (bzw. 1). Hiermit lassen sich besonders günstige Lastverteilungen auf die Stützeinheiten erzielen. Zusätzlich oder alternativ kann die Kopplungseinrichtung dazu konfiguriert sein, den Betrag der Stützkräfte der beiden Stützeinheiten des Stützeinheitenpaars zumindest im Wesentlichen zu egalisieren. Ebenso kann die Kopplungseinrichtung dazu konfiguriert sein, dass eine Abweichung zwischen den Beträgen der Stützkräfte der beiden Stützeinheiten zu minimieren. Beiden letzteren Fällen wird mithin also versucht, ein Verhältnis der Stützkräfte von V = 1 zu erzielen.

Es versteht sich, dass natürlich eine besonders weite Annäherung an den jeweiligen Sollwert der Stützkraft von Vorteil ist. Im Falle möglichst gleich hoher Kräfte (Verhältnis von 1) ist dann natürlich angestrebt, dass die Beträge der beiden Stützkräfte des Stützeinheitenpaars identisch sind. Vorzugsweise ist daher eine erste Stützeinheit des Stützeinheitenpaars dazu konfiguriert ist, eine erste Stützkraft auszuüben, während eine zweite Stützeinheit des Stützeinheitenpaars dazu konfiguriert ist, eine zweite Stützkraft auszuüben. Die Kopplungseinrichtung ist dann derart konfiguriert, dass der Betrag der ersten Stützkraft um weniger als 1,0%, vorzugsweise weniger als 0,5%, weiter vorzugsweise um weniger als 0,1%, von dem Betrag der zweiten Stützkraft abweicht. Bei einem Verhältnis V der Stützkräfte ungleich 1 gilt die vorgenannte Abweichung dann vorzugsweise für die Abweichung der jeweiligen Stützkraft von ihrem jeweiligen Sollwert (gemäß dem jeweiligen Verhältnis).

Die für das Kräftegleichgewicht der beiden Stützkräfte erforderliche Ausgleichsbewegung kann grundsätzlich in beliebiger geeigneter Weise erzeugt werden. Vorzugsweise weist eine erste Stützeinheit des Stützeinheitenpaars eine erste Luftlagereinheit zum Erzeugen einer ersten Stützkraft auf, während eine zweite Stützeinheit des Stützeinheitenpaars eine zweite Luftlagereinheit zum Erzeugen einer zweiten Stützkraft aufweist. Die Kopplungseinrichtung weist eine erste Kopplungseinheit auf, welche die erste Luftlagereinheit zumindest entlang der ersten Stützkraft verschieblich trägt. Weiterhin weist die Kopplungseinrichtung eine zweite Kopplungseinheit auf, welche die zweite Luftlagereinheit zumindest entlang der zweiten Stützkraft verschieblich trägt. Die erste Kopplungseinheit und die zweite Kopplungseinheit sind derart miteinander gekoppelt, dass eine erste Verschiebung entlang der ersten Stützkraft an der ersten Luftlagereinheit eine gegenläufige zweite Verschiebung entlang der zweiten Stützkraft an der zweiten Luftlagereinheit bewirkt. Hierdurch lässt sich die jeweilige Ausgleichsbewegung auf besonders einfache Weise realisieren.

Je nach dem Verhältnis der beiden Stützkräfte können sich dabei unterschiedliche Verschiebungen ergeben. Bei bestimmten Varianten mit einem Verhältnis von 1 ist vorzugsweise vorgesehen, dass der Betrag der ersten Verschiebung zumindest im Wesentlichen gleich dem Betrag der zweiten Verschiebung ist.

Die Anbindung der Kopplungseinheit an der jeweils zugehörigen Luftlagereinheit kann grundsätzlich beliebig gestaltet sein. Insbesondere kann vorgesehen sein, dass erforderliche Bewegungen der Lagerung in bestimmten Freiheitsgraden während der Ausgleichsbewegung bereits durch die Luftlagereinheit zur Verfügung gestellt werden. Bei bestimmten Varianten können derartige Bewegungen aber auch über die jeweilige Anbindung der Kopplungseinheit an ihre zugehörige Luftlagereinheit erfolgen. So kann vorzugsweise die jeweilige Kopplungseinheit über ein Schwenklager mit der zugehörigen Luftlagereinheit verbunden sein, wobei insbesondere eines der beiden Schwenklager genau drei translatorische Freiheitsgrade einschränkt und das andere der beiden Schwenklager genau einen translatorischen Freiheitsgrad einschränkt. Hiermit kann eine typischerweise bevorzugte Anordnung aus Festlager und Loslager in der Kopplungseinrichtung realisiert werden.

Die Kopplung zwischen den Stützeinheiten des Stützeinheitenpaars kann grundsätzlich nach beliebigen geeigneten Wirkprinzipien erfolgen, welche die erforderliche Ausgleichsbewegung (alleine oder in beliebiger Kombination) zur Verfügung stellen. Vorzugsweise handelt es sich (alleine oder in beliebiger Kombination) um eine hydraulische, rein mechanische oder elektronische Kopplung.

Bei bestimmten Varianten kann die Kopplungseinrichtung daher eine hydraulische Kopplungseinrichtung sein. Eine solche hydraulische Kopplung hat den Vorteil, dass sich besonders einfach über eine oder mehrere hydraulische Leitungen realisieren lässt. Insbesondere kann vorgesehen sein, dass die erste Kopplungseinheit eine erste Kolben-Zylinder-Einheit mit einem ersten hydraulischen Arbeitsraum ist, während die zweite Kopplungseinheit eine zweite Kolben-Zylinder-Einheit mit einem zweiten hydraulischen Arbeitsraum ist. Der erste hydraulische Arbeitsraum und der zweite hydraulische Arbeitsraum sind dann einfach hydraulisch miteinander gekoppelt.

Je nach dem zu erzielenden Verhältnis zwischen den Stützkräften der beiden Stützeinheiten des Stützeinheitenpaars kann dieses einfach über die effektive Kolbenfläche der jeweiligen Kolben-Zylinder-Einheit erzielt werden. Insbesondere bei den genannten Varianten mit einem Verhältnis der Stützkräfte von 1 kann vorgesehen sein, dass die beiden Kolben-Zylinder-Einheiten eine zumindest im Wesentlichen identische effektive Kolbenfläche aufweisen.

Die hydraulische Kopplung kann auf beliebige geeignete Weise erfolgen. Vorzugsweise sind der erste hydraulische Arbeitsraum und der zweite hydraulische Arbeitsraum über wenigstens eine Hydraulikleitung miteinander gekoppelt. Hiermit lässt sich eine besonders einfache Kopplung erzielen.

Weiterhin kann eine Drosseleinrichtung zwischen dem ersten und zweiten hydraulischen Arbeitsraum vorgesehen sein, um eine Drosselung des Hydraulikmediums und damit eine Dämpfung der Ausgleichsbewegung zu erzielen. Diese Drosselung kann fest vorgegeben sein. Die Drosselung kann aber auch durch die Drosseleinrichtung aktiv verstellbar sein. Insbesondere können mehrere Hydraulikleitungen zwischen den Arbeitsräumen vorgesehen sein, die selektiv zu- bzw. abschaltbar sind, um den gesamten Durchflussquerschnitt der Verbindung zwischen den Arbeitsräumen und damit die Drosselung zu verändern.

Die Kopplung kann rein passiv nur durch die hydraulische Verbindung der Arbeitsräume realisiert sein. Alternativ kann die Kopplungseinrichtung aber auch eine Pumpeinrichtung zum aktiven Befüllen des ersten und zweiten hydraulischen Arbeitsraums umfassen. Hiermit lassen sich dann gegebenenfalls auch geeignete Reaktionen auf bestimmte dynamische Zustände im Betrieb erzielen, welche ein abweichendes Verhältnis zwischen den Stützkräften des Stützeinheitenpaars erfordern.

Bei weiteren Varianten ist die Kopplungseinrichtung eine mechanische Kopplungseinrichtung. Auch hiermit lassen sich besonders einfache Konfigurationen erzielen. Bevorzugt ist die erste Kopplungseinheit ein erster Arm einer Wippeneinheit ist, während die zweite Kopplungseinheit ein zweiter Arm der Wippeneinheit ist. Der erste Arm und der zweite Arm sind im Bereich eines Schwenklagers der Wippeneinheit miteinander verbunden. Hiermit lässt sich eine besonders einfache und zuverlässige mechanische Kopplung der beiden Stützeinheiten erzielen.

Die Verbindung zwischen dem ersten Arm und den zweiten Arm kann grundsätzlich beliebig gestaltet sein, solange die entsprechend gewünschte Ausgleichsbewegung erzielt wird. Bei bevorzugten, weil besonders einfachen Varianten sind der erste Arm und der zweite Arm miteinander einstückig ausgebildet.

Das Schwenklager der Wippeneinheit kann grundsätzlich in beliebiger geeigneter Weise gestaltet sein. Auch hier können grundsätzlich erforderliche Bewegungen der Lagerung in bestimmten Freiheitsgraden während der Ausgleichsbewegung bereits durch die Luftlagereinheit zur Verfügung gestellt werden. Vorzugsweise schränkt das Schwenklager der Wippeneinheit drei translatorische Freiheitsgrade und zwei rotatorische Freiheitsgrade ein, da hiermit eine besonders einfache Konfiguration erzielt wird. Mit anderen Worten kann das Schwenklager der Wippeneinheit nach Art eines Festlagers ausgebildet sein.

Die Lage des Schwenklagers der Wippeneinheit kann grundsätzlich beliebig gewählt sein, wobei es in einfacher Weise an die geometrischen Bedingungen der optischen Einheit angepasst sein kann. Vorzugsweise ist das Schwenklager der Wippeneinheit im Bereich einer Verbindungslinie der Schwenklager der Kopplungseinheiten angeordnet. Hiermit lassen unerwünschte parasitäre Bewegungen im Bereich der Schwenklager der Kopplungseinheiten weitgehend vermeiden. Dies gilt in besonderem Maße, wenn die Schwenkachse des Schwenklagers der Wippeneinheit diese Verbindungslinie der Schwenklager der Kopplungseinheiten schneidet.

Auch bei dieser Gestaltung kann wiederum eine Dämpfung der Ausgleichsbewegungen an den Stützeinheiten vorgesehen sein. Hierzu kann die Wippeneinheit eine Dämpfungseinrichtung zum Dämpfen der Schwenkbewegung um das Schwenklager der Wippeneinheit umfassen. Dabei kann wiederum vorgesehen sein, dass der Dämpfungswert der Dämpfungseinrichtung insbesondere verstellbar ist.

Es versteht sich, dass die vorbeschriebene mechanische Kopplungseinrichtung eine rein passive Einrichtung sein kann. Ebenso ist aber natürlich denkbar, dass die Kopplungseinrichtung eine aktive Einrichtung ist, bei der die Ausgleichsbewegungen an den Stützeinheiten aktiv beeinflusst werden. Hierbei kann insbesondere die oben beschriebene Dämpfungseinrichtung entsprechend aktiv ausgebildet sein.

Bei bestimmten Varianten ist die Kopplungseinrichtung eine aktive Kopplungseinrichtung. Dies ist insbesondere dann von Vorteil, wenn selektiv auf bestimmte dynamische Betriebszustände der Anordnung reagiert werden soll. Die Gestaltung als aktive Kopplungseinrichtung kann grundsätzlich auf beliebige geeignete Weise realisiert sein. So können beliebige aktive Komponenten vorgesehen sein, welche die Ausgleichsbewegungen an den Stützeinheiten nach beliebigen Wirkprinzipien aktiv erzeugen.

Bei bestimmten Varianten umfasst die erste Kopplungseinheit eine erste Aktuatoreinheit, die mit einer Steuereinrichtung verbunden ist, während die zweite Kopplungseinheit eine zweite Aktuatoreinheit umfasst, die ebenfalls mit der Steuereinrichtung verbunden ist. Die Steuereinrichtung steuert dann die erste und die zweite Aktuatoreinheit zum Einstellen der ersten und zweiten Stützkraft an.

Die Steuerung kann dabei sowohl mit als auch ohne geschlossenen Regelkreis ausgebildet sein. So kann beispielsweise vorgesehen sein, dass die erste Aktuatoreinheit und die zweite Aktuatoreinheit jeweils einen durch die Steuereinrichtung angesteuerten Kraftaktuator (beispielsweise einen Lorentz-Aktuator) umfassen, der in Abhängigkeit von einem Eingangssignal eine (durch das Eingangssignal) vorgegebene Kraft erzeugt. In diesem Fall kann ein offener Regelkreis realisiert sein, mithin also einfach vorgesehen sein, dass die Steuereinrichtung dem Kraftaktuator lediglich ein Eingangssignal vorgibt, anhand dessen der Kraftaktuator die gewünschte Kraft einstellt. Hierbei kann der Kraftaktuator entweder bereits unmittelbar die gewünschte Stützkraft an der Stützeinheit des Stützeinheitenpaars erzeugen oder diese über eine entsprechende Übersetzung zur Verfügung stellen.

Auch bei solchen aktiven Kopplungseinrichtungen kann wiederum vorgesehen sein, dass die Stützstruktur eine Dämpfungseinrichtung zum Dämpfen der durch die Aktuatoreinheiten erzeugten Bewegungen der optischen Einheit umfasst. Auch hier kann der Dämpfungswert der Dämpfungseinrichtung wiederum verstellbar gestaltet sein. Die Dämpfungseinrichtung kann an beliebiger geeigneter Stelle im Kraftfluss zwischen der Stützstruktur und der optischen Einheit vorgesehen sein. Insbesondere kann die Dämpfungseinrichtung mit der optischen Einheit verbindbar sein. Dies gilt im Übrigen nicht nur für die gerade beschriebenen aktiven Kopplungseinrichtungen sondern generell für alle vorstehend und nachfolgend beschriebenen Kopplungseinrichtungen unabhängig von deren Wirkprinzip und genereller Gestaltung.

Über eine solche Dämpfungseinrichtung kann insbesondere unabhängig von Wirkprinzip und genereller Gestaltung der Kopplungseinrichtung in vorteilhafter Weise Einfluss auf die dynamischen Eigenschaften der optischen Einheit genommen werden. So können über eine solche Dämpfungseinrichtung eine oder mehrere Eigenfrequenzen der optischen Einheit beeinflusst bzw. bedämpft werden.

Bei bestimmten Varianten der aktiven Kopplungseinrichtung kann vorgesehen sein, dass die Steuereinrichtung die Aktuatoreinheiten unter Verwendung eines Dämpfungsparameters zum Dämpfen der durch die Aktuatoreinheiten erzeugten Bewegungen der optischen Einheit ansteuert. Auch hier kann der Dämpfungsparameter insbesondere verstellbar sein.

Bei weiteren Varianten der aktiven Kopplungseinrichtung kann ein geschlossener Regelkreis vorgesehen sein. Hierzu kann beispielsweise vorgesehen sein, dass die Steuereinrichtung mit einer ersten Erfassungseinheit verbunden ist, die dazu konfiguriert ist, zumindest einen der ersten Kopplungseinheit zugeordneten ersten Erfassungswert zu erfassen. Weiterhin ist die Steuereinrichtung dann mit einer zweiten Erfassungseinheit verbunden, die dazu konfiguriert ist, zumindest einen der zweiten Kopplungseinheit zugeordneten zweiten Erfassungswert zu erfassen. Der jeweilige Erfassungswert ist dann vorzugsweise für eine Position der zugeordneten Kopplungseinheit entlang der Richtung der zugeordneten Stützkraft und/oder einen Betrag der zugeordneten Stützkraft und/oder einen Luftspalt der zugeordneten Luftlagereinheit repräsentativ. Die Steuereinrichtung ist dann weiterhin dazu konfiguriert, in Abhängigkeit von dem ersten und zweiten Erfassungswert die erste und zweite Aktuatoreinheit anzusteuern.

Es versteht sich, dass die beiden Stützeinheiten des Stützeinheitenpaars grundsätzlich an beliebiger geeigneter Stelle an der optischen Einheit angreifen können. Bei bestimmten Varianten weist die optische Einheit einen Schwerpunkt auf, wobei die Gewichtskraft der optischen Einheit und die Stützkräfte der Stützeinheiten eine Horizontalebene jeweils in einem Kraftschnittpunkt schneiden. Wenigstens die Stützeinheit, deren Kraftschnittpunkt in der Horizontalebene den geringsten Abstand zu dem Kraftschnittpunkt der Gewichtskraft aufweist, bildet eine der beiden Stützeinheiten des wenigstens einen Stützeinheitenpaars. Hiermit kann in einfacher Weise sichergestellt werden, dass gerade die Stützeinheit, die dem Schwerpunkt der optischen Einheit am nächsten liegt und damit grundsätzlich der höchsten Last ausgesetzt ist, durch die zugeordnete zweite Stützeinheit effektiv entlastet ist.

Zusätzlich kann vorgesehen sein, dass die Stützeinheit, deren Kraftschnittpunkt in der Horizontalebene den zweitgeringsten Abstand zu dem Kraftschnittpunkt der Gewichtskraft aufweist, die andere der beiden Stützeinheiten des wenigstens einen Stützeinheitenpaars bildet. Hiermit lässt sich eine besonders effektive Entlastung der Luftlager erzielen.

Auch die Anordnung bzw. relative Lage der Stützeinheiten des Stützeinheitenpaars über den Umfang der optischen Einheit kann grundsätzlich beliebig gewählt sein. Vorzugsweise definiert die optische Einheit in der Horizontalebene eine Umfangsrichtung und die Kraftschnittpunkte der beiden Stützeinheiten des wenigstens einen Stützeinheitenpaars sind in der Umfangsrichtung unmittelbar zueinander benachbart.

Es versteht sich, dass grundsätzlich beliebig viele Stützeinheiten vorgesehen sein können, welche über entsprechende Kopplungseinrichtungen miteinander gekoppelt sind, um die Abstützung der optischen Einheit im Endergebnis wieder auf eine Dreipunktabstützung zurückzuführen. Hierbei können die Kopplungseinrichtungen auch kaskadiert angeordnet sein, beispielsweise also die Kopplungseinrichtungen von zwei Stützeinheitenpaaren ihrerseits über eine entsprechende Kopplungseinrichtung gekoppelt sein.

Bei bestimmten, besonders einfachen Varianten beträgt die Anzahl der Stützeinheiten genau vier. Alternativ kann die Anzahl der Stützeinheiten wenigstens fünf, insbesondere genau fünf, betragen, wobei dann ein von dem Stützeinheitenpaar separates weiteres Stützeinheitenpaar vorgesehen ist. Weiterhin kann die Anzahl der Stützeinheiten alternativ genau sechs betragen, wobei dann zwei von dem Stützeinheitenpaar und voneinander separate weitere Stützeinheitenpaare vorgesehen sind. Diese zusätzlichen Stützeinheitenpaare können dann in beiden Fällen identisch zu dem zuvor beschriebenen Stützeinheitenpaar ausgebildet sein.

Die vorliegende Erfindung betrifft weiterhin eine optische Abbildungseinrichtung, insbesondere für die Mikrolithographie, mit einer Beleuchtungseinrichtung mit einer ersten optischen Elementgruppe, einer Objekteinrichtung zur Aufnahme eines Objekts, einer Projektionseinrichtung mit einer zweiten optischen Elementgruppe und einer Bildeinrichtung.

Die Beleuchtungseinrichtung ist zur Beleuchtung des Objekts ausgebildet, während die Projektionseinrichtung zur Projektion einer Abbildung des Objekts auf die Bildeinrichtung ausgebildet ist. Die Beleuchtungseinrichtung und/oder die Projektionseinrichtung umfasst wenigstens eine Anordnung gemäß der vorliegenden Erfindung. Hiermit lassen sich die oben im Zusammenhang mit der erfindungsgemäßen Anordnung beschriebenen Varianten und Vorteile in demselben Maße erreichen, sodass insoweit auf die obigen Ausführungen Bezug genommen wird.

Die vorliegende Erfindung betrifft weiterhin ein Verfahren zum Abstützen einer optischen Einheit für die Mikrolithographie, insbesondere unter Verwendung von Licht im extremen UV-Bereich (EUV) mittels einer Stützstruktur, wobei die optische Einheit mittels einer Anzahl von separaten Stützeinheiten der Stützstruktur abgestützt wird, indem jede der Stützeinheiten über ein Luftlager eine Stützkraft erzeugt, welche der Gewichtskraft der optischen Einheit entgegenwirkt. Auch hier kann die Masse der optischen Einheit insbesondere 4 t bis 14 t, vorzugsweise 5 t bis 10 t, weiter vorzugsweise 6 t bis 8 t, betragen. Die Anzahl der Stützeinheiten beträgt wenigstens vier, wobei wenigstens zwei der Stützeinheiten derart über eine Kopplungseinrichtung zu einem Stützeinheitenpaar gekoppelt werden, dass die Kopplungseinrichtung einer Abweichung von einem vorgebbaren Verhältnis der beiden Stützkräften der beiden Stützeinheiten des Stützeinheitenpaars entgegenwirkt. Hiermit lassen sich wiederum die oben im Zusammenhang mit der erfindungsgemäßen Anordnung beschriebenen Varianten und Vorteile in demselben Maße erreichen, sodass insoweit auf die obigen Ausführungen Bezug genommen wird.

Die vorliegende Erfindung betrifft schließlich ein optisches Abbildungsverfahren, insbesondere für die Mikrolithographie, bei dem über eine Beleuchtungseinrichtung mit einer ersten optischen Elementgruppe ein Objekt beleuchtet wird und mittels einer Projektionseinrichtung mit einer zweiten optischen Elementgruppe eine Abbildung des Objekts auf einer Bildeinrichtung erzeugt wird. In der Beleuchtungseinrichtung und/oder der Projektionseinrichtung wird, insbesondere während des Erzeugens der Abbildung, ein erfindungsgemäßes Verfahren zum Abstützen einer optischen Einheit verwendet. Hiermit lassen sich ebenfalls die oben im Zusammenhang mit der erfindungsgemäßen Anordnung beschriebenen Varianten und Vorteile in demselben Maße erreichen, sodass insoweit auf die obigen Ausführungen Bezug genommen wird.

Weitere Aspekte und Ausführungsbeispiele der Erfindung ergeben sich aus den abhängigen Ansprüchen und der nachfolgenden Beschreibung bevorzugter Ausführungsbeispiele, die sich auf die beigefügten Figuren bezieht.

### KURZE BESCHREIBUNG DER ZEICHNUNGEN

- Figur 1: ist eine schematische Darstellung einer bevorzugten Ausführung einer erfindungsgemäßen Projektionsbelichtungsanlage, die eine bevorzugte Ausführung einer erfindungsgemäßen Anordnung umfasst und mit der bevorzugte Ausführungen der erfindungsgemäßen Verfahren ausgeführt werden können.
- Figur 2: ist eine schematische Seitenansicht der erfindungsgemäßen Anordnung aus Figur 1.
- Figur 3: ist eine weitere schematische Seitenansicht Anordnung aus Figur 2.
- Figur 4: ist eine schematische Draufsicht auf die Anordnung aus Figur 2.
- Figur 5: ist eine schematische Seitenansicht einer weiteren Ausführungsform der erfindungsgemäßen Anordnung.
- Figur 6: ist eine schematische Seitenansicht einer weiteren Ausführungsform der erfindungsgemäßen Anordnung.

### DETAILLIERTE BESCHREIBUNG DER ERFINDUNG

### Erstes Ausführungsbeispiel

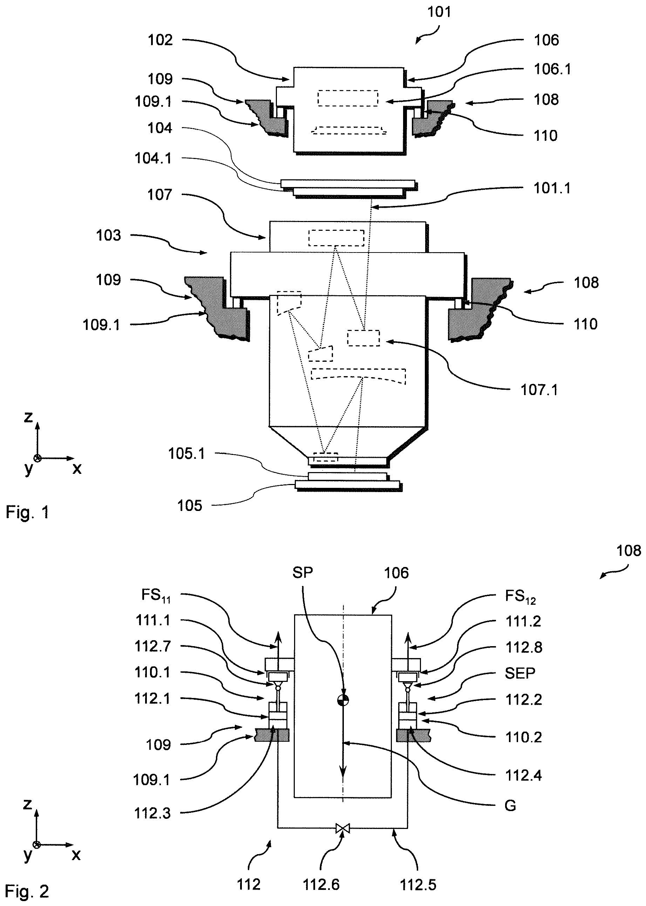

Im Folgenden wird unter Bezugnahme auf die Figuren 1 bis 4 ein bevorzugtes Ausführungsbeispiel einer erfindungsgemäßen Projektionsbelichtungsanlage 101 für die Mikrolithographie beschrieben, die ein bevorzugtes Ausführungsbeispiel einer erfindungsgemäßen Anordnung zum Abstützen einer optischen Einheit umfasst. Zur Vereinfachung der nachfolgenden Ausführungen wird in den Zeichnungen ein x,y,z-Koordinatensystem angegeben, wobei die z-Richtung der Richtung der Gravitationskraft entspricht. Selbstverständlich ist es in weiteren Ausgestaltungen möglich, beliebige davon abweichende Orientierungen eines x,y,z-Koordinatensystems zu wählen.

Figur 1 ist eine schematische, nicht maßstabsgetreue Darstellung der Projektionsbelichtungsanlage 101, die in einem Mikrolithographieprozess zur Herstellung von Halbleiterbauelementen verwendet wird. Die Projektionsbelichtungsanlage 101 umfasst eine Beleuchtungseinrichtung 102 und eine Projektionseinrichtung 103. Die Projektionseinrichtung 103 ist dazu ausgebildet, in einem Belichtungsprozess ein Bild einer Struktur einer Maske 104.1, die in einer Maskeneinheit 104 angeordnet ist, auf ein Substrat 105.1 zu übertragen, das in einer Substrateinheit 105 angeordnet ist. Dazu beleuchtet die Beleuchtungseinrichtung 102 die Maske 104.1. Die optische Projektionseinrichtung 103 empfängt das Licht von der Maske 104.1 und projiziert das Bild der Maskenstruktur der Maske 104.1 auf das Substrat 105.1, wie z.B. einen Wafer oder dergleichen.

Die Beleuchtungseinrichtung 102 umfasst eine optische Einheit 106 mit einer optischen Elementgruppe 106.1. Die Projektionseinrichtung 103 umfasst eine weitere optische Einheit 107 mit einer optischen Elementgruppe 107.1. Die optischen Elementgruppen 106.1, 107.1 sind entlang einer gefalteten optischen Achse 101.1 der Projektionsbelichtungsanlage 101 angeordnet. Jede der optischen Elementgruppen 106.1, 107.1 kann eine Vielzahl optischer Elemente umfassen.

In dem vorliegenden Ausführungsbeispiel arbeitet die Projektionsbelichtungsanlage 101 mit Nutzlicht im EUV-Bereich (extrem ultraviolette Strahlung), mit Wellenlängen zwischen 5 nm bis 20 nm, insbesondere mit einer Wellenlänge von 13 nm. Bei den optischen Elementen der Elementgruppen 106.1, 107.1 der Beleuchtungseinrichtung 102 und der Projektionseinrichtung 103 handelt es sich daher ausschließlich um reflektive optische Elemente. Die optischen Einheiten 106 und 107 sind systembedingt schwere Komponenten, deren Masse etwa 6 t bis 8 t beträgt. Bei weiteren Varianten kann die Masse der optischen Einheiten 106 bzw. 107 4 t bis 14 t, vorzugsweise 5 t bis 10 t, weiter vorzugsweise 6 t bis 8 t, betragen. Die optischen Einheiten 106 und 107 sind jeweils über eine bevorzugte Ausführungsform der erfindungsgemäßen Anordnung 108 abgestützt.

In weiteren Ausgestaltungen der Erfindung ist es (insbesondere in Abhängigkeit von der Wellenlänge des Beleuchtungslichts) selbstverständlich auch möglich, für die übrigen optischen Module jede Art von optischen Elementen (refraktiv, reflektiv, diffraktiv) alleine oder in beliebiger Kombination einzusetzen. Weiterhin können die Beleuchtungseinrichtung 102 und/oder die Projektionseinrichtung 103 eine oder mehrere optische Einheiten wie die optische Einheit 106 bzw. 107 umfassen.

Die Anordnung 108 wird im Folgenden beispielhaft anhand der Anordnung 108 beschrieben, welche die optische Einheit 106 abstützt. Es versteht sich, dass die nachfolgenden Ausführungen auch für die Anordnung 108 gelten, welche die optische Einheit 107 abstützt. Diese kann insbesondere identisch zu der nachfolgend beschriebenen Anordnung 108 gestaltet sein.

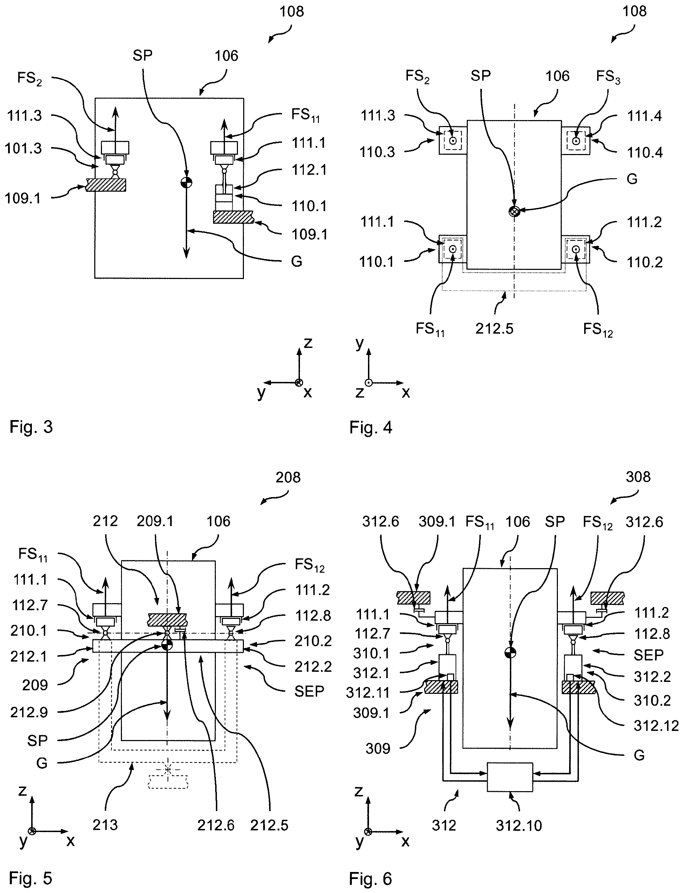

Die Figuren 2 und 3 zeigen jeweils schematische Seitenansichten (Figur 2: auf die xz-Ebene bzw. entlang der y-Achse; Figur 3: auf die yz-Ebene bzw. entlang der x-Achse) auf die Anordnung 108, welche die optische Einheit 106 abstützt, während die Figur 4 eine schematische Draufsicht (auf die yz-Ebene bzw. entlang der z-Achse) auf die Anordnung 108 zeigt.

Wie den Figuren 2 bis 4 zu entnehmen ist, umfasst die Anordnung 108 eine Stützstruktur 109 zum Abstützen der optischen Einheit 106 auf einer oder mehreren Stützeinheiten 109.1, beispielsweise einem Stützrahmen 109.1, der Stützstruktur 109, die ihrerseits in beliebiger geeigneter (und hinlänglich bekannter) Weise auf einer Bodenstruktur (nicht dargestellt) abgestützt ist.

Die Stützstruktur 109 umfasst eine Anzahl von separaten Stützeinheiten 110, nämlich genau vier Stützeinheiten 110.1 bis 110.4, zum Abstützen der optischen Einheit 106. Jede der Stützeinheiten 110.1 bis 110.4 umfasst eine Luftlagereinheit in Form eines Luftlagers 111.1 bis 111.4. Diese Luftlager 111.1 bis 111.4 sind in hinlänglich bekannter Weise gestaltet (sodass hierauf nicht näher eingegangen wird). Über jedes Luftlager 111.1 bis 111.4 kann jeweils eine zugeordnete Stützkraft FS₁₁, FS₁₂, FS₂ bzw. FS₃ erzeugt werden, welche der Gewichtskraft G der optischen Einheit 106 entgegenwirkt.

Eine erste Stützeinheit 110.1 und eine zweite Stützeinheit 110.2 sind dabei über eine Kopplungseinrichtung 112 zu einem Stützeinheitenpaar SEP gekoppelt. Die Kopplung ist derart, dass die Kopplungseinrichtung 112 einer Abweichung der zugeordneten Stützkräfte FS₁₁ und FS₁₂ von einem vorgebbaren Verhältnis V der Stützkräfte FS₁₁ und FS₁₂ der beiden Stützeinheiten 110.1 und 110.2 entgegenwirkt, wie dies nachfolgend noch im Detail beschrieben wird.

Das Verhältnis V der beiden Stützkräfte FS₁₁ und FS₁₂ der Stützeinheiten 110.1 und 110.2 kann grundsätzlich die beliebig gewählt sein und an die geometrischen Bedingungen und die Massenverteilung (mithin also auch die Lage des Schwerpunkts SP) der optischen Einheit 106 angepasst sein. Dabei können insbesondere auch die dynamischen Bedingungen während des Betriebs der Abbildungseinrichtung 101 und damit der Anordnung 108 Berücksichtigung finden. So kann es zwar unter statischen Bedingungen typischerweise von Vorteil sein, wenn das Verhältnis der Stützkräfte bei V = 1 liegt, da dann eine möglichst gleichmäßige Verteilung der Lasten erzielt wird. Erfährt aber eine der Stützeinheiten 110.1 bis 110.4 unter dynamischen Bedingungen (beispielsweise durch Schwingungsanregung) stark erhöhte Stützkraft, so kann es sinnvoll sein, diese unter statischen Bedingungen zu reduzieren, um den dynamischen Maximalbetrag FSₘₐₓ zu reduzieren (und natürlich unter der Maximalkraft Fₘₐₓ zu halten).

Im vorliegenden Beispiel liegt das Verhältnis der Stützkräfte FS₁₁ und FS₁₂ im statischen Zustand (mithin also im Ruhezustand der Abbildungseinrichtung 101) bei V = 1. Es versteht sich jedoch, dass bei anderen vorteilhaften Varianten das vorgebbare Verhältnis der Stützkräfte 1/3 (bzw. ca. 0,33) bis 1/1 (bzw. 1), vorzugsweise 1/2 (bzw. 0,5) bis 1/1 (bzw. 1), weiter vorzugsweise 2/3 (bzw. ca. 0,66) bis 1/1 (bzw. 1) betragen kann, um je nach Anwendungsfall besonders günstige Lastverteilungen auf die Stützeinheiten 110.1 bis 110.4 zu erzielen.

Demgemäß ist die Kopplungseinrichtung 112 im vorliegenden Beispiel dazu konfiguriert, den Betrag der Stützkräfte FS₁₁ und FS₁₂ der beiden Stützeinheiten 110.1 und 110.2 des Stützeinheitenpaars SEP zumindest im Wesentlichen zu egalisieren, mithin also eine Abweichung DFS zwischen den Beträgen der Stützkräfte FS₁₁ und FS₁₂ der beiden Stützeinheiten 110.1 und 110.2 zu minimieren (im Optimalfall also eine Abweichung DFS = 0 zu erreichen).

Es versteht sich, dass natürlich eine besonders weite Annäherung an den jeweiligen Sollwert der Stützkraft von Vorteil ist. Die Kopplungseinrichtung 112 ist folglich derart konfiguriert, dass der Betrag der ersten Stützkraft FS₁₁ um weniger als 1,0%, vorzugsweise weniger als 0,5%, weiter vorzugsweise um weniger als 0,1%, von dem Betrag der zweiten Stützkraft FS₁₂ abweicht.

Um das beschriebene Kräftegleichgewicht der beiden Stützkräfte FS₁₁ und FS₁₂ zu erzielen, erzeugt die Kopplungseinrichtung 112 im vorliegenden Beispiel eine Ausgleichsbewegung im Bereich der Luftlager 111.1 und 111.2, sodass dort bei gleichem Lagerdruck (Luftdruck im Luftspalt) eine gleiche Spaltbreite des Luftspaltes vorliegt. Hierzu ist die Kopplungseinrichtung 112 als hydraulische Kopplungseinrichtung gestaltet. Hierzu weist die Kopplungseinrichtung 112 eine erste Kopplungseinheit in Form einer ersten Kolben-Zylinder-Einheit 112.1 auf, welche die erste Luftlagereinheit 111.1 entlang der ersten Stützkraft FS₁₁ verschieblich trägt. Weiterhin weist die Kopplungseinrichtung 112 eine zweite Kopplungseinheit in Form einer zweiten Kolben-Zylinder-Einheit 112.2 auf, welche die zweite Luftlagereinheit 111.2 entlang der zweiten Stützkraft FS₁₂ verschieblich trägt.

Die erste Kopplungseinheit 112.1 und die zweite Kopplungseinheit 112.2 sind derart miteinander gekoppelt, dass eine erste Verschiebung DS1 entlang der ersten Stützkraft FS₁₁ an der ersten Luftlagereinheit 111.1 eine gegenläufige zweite Verschiebung DS2 entlang der zweiten Stützkraft FS₁₂ an der zweiten Luftlagereinheit 111.2 bewirkt.

Es versteht sich dabei, dass sich je nach dem Verhältnis V der beiden Stützkräfte dabei unterschiedliche Verschiebungen DS1 und DS2 ergeben können. Im vorliegenden Beispiel mit einem Verhältnis von V = 1 ist der Betrag der ersten Verschiebung DS1 zumindest im Wesentlichen gleich dem Betrag der zweiten Verschiebung DS2.

Die hydraulische Kopplung ist im vorliegenden Beispiel dadurch realisiert, dass der (erste) hydraulische Arbeitsraum 112.3 der ersten Kopplungseinheit 112.1 mit dem (zweiten) hydraulischen Arbeitsraum 112.4 der zweiten Kopplungseinheiten 112.2 über eine einfache Hydraulikleitung 112.5 hydraulisch gekoppelt ist.

Je nach dem zu erzielenden Verhältnis V zwischen den Stützkräften FS₁₁ und FS₁₂ der beiden Stützeinheiten 110.1 und 110.2 des Stützeinheitenpaars SEP kann dieses einfach über die effektive Kolbenfläche der jeweiligen Kolben-Zylinder-Einheit 112.1 und 112.2 erzielt werden. Im vorliegenden Beispiel mit einem Verhältnis V = 1 weisen die beiden Kolben-Zylinder-Einheiten 112.1 und 112.2 demgemäß eine zumindest im Wesentlichen identische effektive Kolbenfläche auf.

Im vorliegenden Beispiel ist in der Hydraulikleitung 112.5 weiterhin eine Drosseleinrichtung 112.6 zwischen dem ersten und zweiten hydraulischen Arbeitsraum 112.3, 112.4 vorgesehen, um eine Drosselung des Hydraulikmediums und damit eine Dämpfung der Ausgleichsbewegung zu erzielen. Diese Drosselung kann fest vorgegeben sein. Sie kann aber auch durch die Drosseleinrichtung 112.6 aktiv verstellbar sein. Weiterhin können bei weiteren Varianten mehrere Hydraulikleitungen zwischen den Arbeitsräumen 112.3, 112.4 vorgesehen sein, die (beispielsweise über die Drosseleinrichtung 112.6) selektiv zu- bzw. abschaltbar sind, um den gesamten Durchflussquerschnitt der Verbindung zwischen den Arbeitsräumen 112.3, 112.4 und damit die Drosselung zu verändern.

Die hydraulische Kopplung ist im vorliegenden Beispiel rein passiv nur durch die hydraulische Verbindung der Arbeitsräume 112.3 und 112.4 realisiert. Alternativ kann die Kopplungseinrichtung 112 (zusätzlich oder alternativ zu der Drosseleinrichtung 112.6) aber auch eine Pumpeinrichtung zum aktiven Befüllen des ersten und zweiten hydraulischen Arbeitsraums 112.3, 112.4 umfassen. Hiermit lassen sich dann gegebenenfalls auch geeignete Reaktionen auf bestimmte dynamische Zustände im Betrieb erzielen, welche ein abweichendes Verhältnis V zwischen den Stützkräften FS₁₁ und FS₁₂ der beiden Stützeinheiten 110.1 und 110.2 des Stützeinheitenpaars SEP erfordern.

Die Anbindung der jeweiligen Kopplungseinheit 112.1, 112.2 an der jeweils zugehörigen Luftlagereinheit 111.1, 111.2 kann grundsätzlich beliebig gestaltet sein. Insbesondere kann vorgesehen sein, dass erforderliche Bewegungen der Lagerung in bestimmten Freiheitsgraden während der Ausgleichsbewegung bereits durch die Luftlagereinheit 111.1 bzw. 111.2 zur Verfügung gestellt werden. Bei bestimmten Varianten können derartige Bewegungen aber auch über die jeweilige Anbindung der Kopplungseinheit 112.1, 112.2 an ihre zugehörige Luftlagereinheit 111.1, 111.2 erfolgen.

Im vorliegenden Beispiel ist die jeweilige Kopplungseinheit 112.1 bzw. 112.2 über ein Schwenklager 112.7 bzw. 112.8 mit der zugehörigen Luftlagereinheit 111.1 bzw. 111.2 verbunden. Dabei schränkt das Schwenklager 112.7 genau drei translatorische Freiheitsgrade ein, während es die übrigen drei Freiheitsgrade im Raum nicht einschränkt. Das Schwenklager 112.8 schränkt genau einen translatorischen Freiheitsgrad, während es die übrigen fünf Freiheitsgrade im Raum nicht einschränkt. Hiermit wird letztlich eine vorteilhafte Anordnung aus Festlager und Loslager in der Kopplungseinrichtung 112 realisiert werden.

Durch diese Kopplung der beiden Stützeinheiten 110.1 und 110.2 zu einem Stützeinheitenpaar SEP kann erreicht werden, dass sich die Abstützung der optischen Einheit 106 trotz der vier Stützeinheiten 110.1 bis 110.4 mechanisch wie eine statisch bestimmte Dreipunktabstützung verhält. Mithin kann also trotz der vier Stützstellen die Einleitung parasitärer Spannungen bzw. Deformationen in die optische Einheit 106 zumindest weitestgehend vermieden werden. Dadurch dass vier Stützeinheiten 110.1 bis 110.4 vorgesehen sind, reduziert sich in einfacher Weise zum einen die aus der Gewichtskraft G der optischen Einheit 106 resultierende Last je Luftlager 111.1 bis 111.4 und ermöglicht somit den Einsatz solcher Luftlager 111.1 bis 111.4 auch bei einer derart schweren optischen Einheit 106.

Zudem sorgt die Kopplung der beiden Stützeinheiten 110.1 und 110.2 des Stützeinheitenpaars SEP in einfacher Weise dafür, dass Abweichungen in Position und/oder Ausrichtung an den beiden Stützstellen 110.1 und 110.2 von ihrem Soll-Zustand in einfacher Weise ausgeglichen werden und damit stets das Soll-Verhältnis V (im vorliegenden Beispiel V = 1) der beiden Stützkräfte FS₁₁ und FS₁₂ des Stützeinheitenpaars SEP vorliegt. Solche Abweichungen können durch Fertigungsungenauigkeiten bedingt sein, sich aber auch erst im Betrieb durch störungsbedingte Deformationen der Rahmenstruktur 109.1 und/oder der Struktur der optischen Einheit 106 ergeben.

Mit der vorliegenden Kopplung der Stützeinheiten 110.1 und 110.2 über die Kopplungseinrichtung 112 wird mit anderen Worten eine Master-Slave-Konfiguration realisiert, bei der ein Ungleichgewicht der beiden Stützkräfte (d. h. ihre Abweichung von ihrem Soll-Verhältnis) durch eine über die Kopplungseinrichtung 112 vermittelte Ausgleichsbewegung an den beiden Stützstellen ausgeglichen wird und somit das Gleichgewicht der beiden Stützkräfte FS₁₁ und FS₁₂ (mithin also ihr Soll-Verhältnis V) hergestellt wird. Letztlich kann im Optimalfall hierdurch erreicht werden, dass sich das Stützeinheitenpaar SEP im Ergebnis wie eine einzige Stützeinheit verhält und somit letztlich wiederum eine Dreipunktlagerung realisiert ist, über die eine statische bestimmte Abstützung der optischen Einheit 106 erzielt werden kann.

Es sei nochmals angemerkt, dass das Verhältnis der beiden Stützkräfte FS₁₁ und FS₁₂ des Stützeinheitenpaars SEP grundsätzlich beliebig geeignet gewählt sein kann. Limitierend ist hier lediglich die Maximalkraft Fₘₐₓ, die mittels jeder der Stützeinheiten 110.1 bis 110.4 bzw. ihres Luftlagers 111.1 bis 111.4 aufgenommen werden kann. Mithin muss also die Entlastung durch die (gegenüber einer herkömmlichen Dreipunktlagerung mit drei Stützeinheiten) zusätzliche vierte Stützeinheit so groß sein, dass diese Maximalkraft Fₘₐₓ an den übrigen Stützeinheiten (in allen erforderlichen Betriebszuständen) unterschritten wird. Gegebenenfalls sind dabei auch dynamische Zustände zu berücksichtigen, da die Luftlager 111.1 bis 111.4 häufig auch Einschränkungen hinsichtlich des Verhältnisses der maximalen Lagerkraft FSₘₐₓ zur minimalen Lagerkraft FSₘᵢₙ im Betrieb unterliegen.

Es versteht sich, dass die beiden Stützeinheiten 110.1 und 110.2 des Stützeinheitenpaars SEP grundsätzlich an beliebiger geeigneter Stelle an der optischen Einheit 106 angreifen können. Im vorliegenden Beispiel schneiden die Gewichtskraft G der optischen Einheit 106 und die Stützkräfte FS₁₁ bis FS₃ der Stützeinheiten 110.1 bis 110.4 eine Horizontalebene (Zeichnungsebene der Figur 4) jeweils in einem Kraftschnittpunkt, wobei der Kraftschnittpunkt der beiden Stützeinheiten 110.1 und 110.2 in der Horizontalebene den geringsten Abstand zu dem Kraftschnittpunkt der Gewichtskraft G aufweist. Hiermit kann in einfacher Weise sichergestellt werden, dass gerade die Stützeinheiten 110.1 und 110.2, die dem Schwerpunkt SP der optischen Einheit 106 am nächsten liegen und damit grundsätzlich der höchsten Last ausgesetzt ist, durch die zugeordnete Stützeinheit 110.2 bzw. 110.1 effektiv entlastet sind.

Weiterhin sind die Stützeinheiten 110.1 und 110.2 des Stützeinheitenpaars SEP so angeordnet, dass ihre Kraftschnittpunkte in der Horizontalebene in der Umfangsrichtung der optischen Einheit 106 zueinander unmittelbar benachbart sind.

Mit der vorstehend beschriebenen Gestaltung lässt sich während des Betriebs der Abbildungseinrichtung 101 eine entsprechende bevorzugte Ausführungsform des erfindungsgemäßen Verfahrens zum Abstützen der optischen Einheit 106 realisieren, welche während des Abbildungsverfahrens zur Anwendung kommt, mit dem das Bild der Maskenstruktur der Maske 104.1 auf das Substrat 105.1 projiziert wird. Die einzelnen Verfahrensschritte ergeben sich dabei aus der obigen Beschreibung, sodass insoweit auf die obigen Ausführungen verwiesen wird.

Es versteht sich, dass abweichend von dem vorstehenden Ausführungsbeispiel grundsätzlich mehr als vier Stützeinheiten 110 vorgesehen sein können, welche über entsprechende Kopplungseinrichtungen 112 miteinander gekoppelt sind, um die Abstützung der optischen Einheit 106 im Endergebnis wieder auf eine Dreipunktabstützung zurückzuführen. Hierbei können die Kopplungseinrichtungen 112 auch kaskadiert angeordnet sein, beispielsweise also die Kopplungseinrichtungen 112 von zwei Stützeinheitenpaaren SEP ihrerseits über eine entsprechende Kopplungseinrichtung 112 gekoppelt sein.

Insbesondere kann beispielsweise vorgesehen sein, dass der dritten Stützeinheit 110.3 eine weitere (fünfte) Stützeinheit zugeordnet und über eine weitere (zweite) Kopplungseinrichtung 112 mit der dritten Stützeinheit gekoppelt wird, sodass ein weiteres (zweites) Stützeinheitenpaar SEP gebildet ist. Die Kopplung und Abstützung für dieses weitere (zweite) Stützeinheitenpaar auf der Rahmenstruktur 109.1 kann dann analog zu der Kopplung und Abstützung zwischen den beiden Stützeinheiten 110.1 und 110.2 des (ersten) Stützeinheitenpaars SEP erfolgen. In diesem Fall beträgt dann die Anzahl der Stützeinheiten genau fünf, wobei zwei Stützeinheitenpaare SEP gebildet sind.

In einer weiteren Variante kann dann vorgesehen sein, dass auch der vierten Stützeinheit 110.4 eine weitere (sechste) Stützeinheit zugeordnet und über eine weitere (dritte) Kopplungseinrichtung 112 mit der vierten Stützeinheit gekoppelt wird, sodass ein weiteres (drittes) Stützeinheitenpaar SEP gebildet ist. Die Kopplung und Abstützung für dieses weitere (dritte) Stützeinheitenpaar auf der Rahmenstruktur 109.1 kann dann analog zu der Kopplung und Abstützung zwischen den beiden Stützeinheiten 110.1 und 110.2 des (ersten) Stützeinheitenpaars SEP erfolgen. In diesem Fall beträgt dann die Anzahl der Stützeinheiten genau sechs, wobei drei Stützeinheitenpaare SEP gebildet sind.

### Zweites Ausführungsbeispiel

Im Folgenden wird unter Bezugnahme auf die Figuren 1, 4 und 5 eine weitere bevorzugte Ausführungsform der erfindungsgemäßen Anordnung 208 beschrieben, welche anstelle der Anordnung 108 in der Abbildungseinrichtung 101 verwendet werden kann. Die Anordnung 208 entspricht in ihrer grundsätzlichen Gestaltung und Funktionsweise der Anordnung 108 aus Figur 2 bis 4, sodass hier lediglich auf die Unterschiede eingegangen werden soll. Insbesondere sind identische Komponenten mit den identischen Bezugszeichen versehen, während gleichartige Komponenten mit um den Wert 100 erhöhten Bezugszeichen versehen sind. Sofern nachfolgend nichts Anderweitiges ausgeführt wird, wird hinsichtlich der Merkmale, Funktionen und Vorteile dieser Komponenten auf die obigen Ausführungen im Zusammenhang mit dem ersten Ausführungsbeispiel verwiesen.

Der Unterschied zu dem ersten Ausführungsbeispiel besteht darin, dass die Kopplungseinrichtung 212 als mechanische Kopplungseinrichtung ausgeführt ist. Dabei ist die erste Kopplungseinheit ein erster Arm 212.1 einer Wippeneinheit 212.5, der die erste Stützeinheit 210.1 trägt. Die zweite Kopplungseinheit ist ein zweiter Arm 212.2 der Wippeneinheit 212.5, der die zweite Stützeinheit 210.2 trägt. Der erste Arm 212.1 und der zweite Arm 212.2 sind im Bereich eines Schwenklagers 212.9 der Wippeneinheit 212.5 miteinander verbunden, um eine einfache und zuverlässige mechanische Kopplung der beiden Stützeinheiten 210.1 und 210.2 zu erzielen.

Die Verbindung zwischen dem ersten Arm 210.1 und den zweiten Arm 210.2 kann grundsätzlich beliebig gestaltet sein, solange die entsprechend gewünschte Ausgleichsbewegung erzielt wird. Im vorliegenden Beispiel sind der erste Arm 210.1 und der zweite Arm 210.2 miteinander einstückig ausgebildet. Die Wippeneinheit 212.5 ist dabei in der Draufsicht im Wesentlichen U-förmig gestaltet und seitlich der optischen Einheit 106 angeordnet, wie dies in Figur 4 durch die gepunktete Kontur 212.5 angedeutet ist.

Die Wippeneinheit 212.5 ist über das Schwenklager 212.9 an der Rahmeneinheit 209.1 der Stützstruktur 209 schwenkbar angelenkt. Das Schwenklager 212.9 der Wippeneinheit 212.5 kann grundsätzlich in beliebiger geeigneter Weise gestaltet sein. Auch hier können grundsätzlich erforderliche Bewegungen der Lagerung in bestimmten Freiheitsgraden während der Ausgleichsbewegung bereits durch die Luftlagereinheiten 111.1 und 111.2 zur Verfügung gestellt werden. Im vorliegenden Beispiel schränkt das Schwenklager 212.9 der Wippeneinheit 212.5 drei translatorische Freiheitsgrade und zwei rotatorische Freiheitsgrade ein, da hiermit eine besonders einfache Konfiguration erzielt wird. Mit anderen Worten kann das Schwenklager 212.9 der Wippeneinheit 212.5 also ebenfalls nach Art eines Festlagers ausgebildet sein.

Die Lage des Schwenklagers 212.9 der Wippeneinheit 212.5 kann grundsätzlich beliebig gewählt sein, wobei es in einfacher Weise an die geometrischen Bedingungen der optischen Einheit 106 angepasst sein kann. Vorzugsweise ist das Schwenklager 212.7 der Wippeneinheit 212.5 im Bereich einer Verbindungslinie der Schwenklager 112.7 und 112.8 angeordnet, über welche die jeweilige Luftlagereinheit 111.1 bzw. 111.2 an der jeweils zugehörigen Kopplungseinheit 212.1 bzw. 212.2 angelenkt ist. Hiermit lassen unerwünschte parasitäre Bewegungen im Bereich der Schwenklager 112.7 und 112.8 der Kopplungseinheiten 212.1 bzw. 212.2 weitgehend vermeiden. Dies gilt in besonderem Maße, wenn, wie im vorliegenden Beispiel, die Schwenkachse des Schwenklagers 212.9 der Wippeneinheit 212.5 diese Verbindungslinie der Schwenklager 112.7, 112.8 der Kopplungseinheiten 212.1 bzw. 212.2 schneidet.

Es versteht sich jedoch, dass bei anderen Varianten auch eine beliebige andere Anordnung des Schwenklagers 212.9 sowie eine anderweitige Gestaltung der Wippeneinheit 212.5 gewählt sein kann. Beispielsweise kann eine im Wesentlichen U-förmige Gestaltung der Wippeneinheit mit einer Schwenklagerung unterhalb der optischen Einheit 106 vorgesehen sein, wie sie in Figur 5 durch die gestrichelte Kontur 213 angedeutet ist.

Die erste Kopplungseinheit 212.1 und die zweite Kopplungseinheit 212.2 sind derart über die Wippeneinheit 212.5 miteinander gekoppelt, dass eine erste Verschiebung DS1 entlang der ersten Stützkraft FS₁₁ an der ersten Luftlagereinheit 111.1 eine gegenläufige zweite Verschiebung DS2 entlang der zweiten Stützkraft FS₁₂ an der zweiten Luftlagereinheit 111.2 bewirkt.

Über das Hebelverhältnis zwischen dem ersten Arm 212.1 und dem zweiten Arm 212.2 kann auch hier wiederum das Verhältnis V zwischen den Stützkräften FS₁₁ und FS₁₂ der beiden Stützeinheiten 210.1 und 210.2 des Stützeinheitenpaars SEP eingestellt werden. Im vorliegenden Beispiel ist wiederum ein Verhältnis V = 1 gewählt. Hierzu weisen der erste Arm 212.1 und der zweite Arm 212.2 (bzw. die Stützkräfte FS₁₁ und FS₁₂) bezüglich des Schwenklagers 212.9 zumindest im Wesentlichen denselben effektiven Hebelarm auf.

Auch bei dieser Gestaltung kann wiederum eine Dämpfung der Ausgleichsbewegungen an den Stützeinheiten 210.1 und 210.2 vorgesehen sein. Hierzu kann die Wippeneinheit 212.5 eine Dämpfungseinrichtung 212.6 zum Dämpfen der Schwenkbewegung um das Schwenklager 212.9 der Wippeneinheit 212.5 umfassen, welche zwischen die Wippeneinheit 212.5 und die Rahmenstruktur 209.1 geschaltet ist. Dabei kann wiederum vorgesehen sein, dass der Dämpfungswert der Dämpfungseinrichtung 212.6 verstellbar ist.

Es versteht sich, dass die vorbeschriebene mechanische Kopplungseinrichtung 212 eine rein passive Einrichtung sein kann. Ebenso ist aber natürlich denkbar, dass die Kopplungseinrichtung 212 eine aktive Einrichtung ist, bei der die Ausgleichsbewegungen an den Stützeinheiten 210.1 und 210.2 aktiv beeinflusst werden. Hierbei kann insbesondere die oben beschriebene Dämpfungseinrichtung 212.6 entsprechend aktiv ausgebildet sein. Ebenso kann die Dämpfungseinrichtung 212.6 durch einen entsprechenden Aktuator ersetzt oder ergänzt sein.

Auch mit der vorstehend beschriebenen Gestaltung mit der mechanischen Kopplungseinrichtung 212 lässt sich während des Betriebs der Abbildungseinrichtung 101 eine entsprechende bevorzugte Ausführungsform des erfindungsgemäßen Verfahrens zum Abstützen der optischen Einheit 106 realisieren, welche während des Abbildungsverfahrens zur Anwendung kommt, mit dem das Bild der Maskenstruktur der Maske 104.1 auf das Substrat 105.1 projiziert wird. Die einzelnen Verfahrensschritte ergeben sich dabei aus der obigen Beschreibung, sodass insoweit auf die obigen Ausführungen verwiesen wird.

### Drittes Ausführungsbeispiel

Im Folgenden wird unter Bezugnahme auf die Figuren 1 und 6 eine weitere bevorzugte Ausführungsform der erfindungsgemäßen Anordnung 308 beschrieben, welche anstelle der Anordnung 108 in der Abbildungseinrichtung 101 verwendet werden kann. Die Anordnung 308 entspricht in ihrer grundsätzlichen Gestaltung und Funktionsweise der Anordnung 108 aus Figur 2 bis 4, sodass hier lediglich auf die Unterschiede eingegangen werden soll. Insbesondere sind identische Komponenten mit den identischen Bezugszeichen versehen, während gleichartige Komponenten mit um den Wert 200 erhöhten Bezugszeichen versehen sind. Sofern nachfolgend nichts Anderweitiges ausgeführt wird, wird hinsichtlich der Merkmale, Funktionen und Vorteile dieser Komponenten auf die obigen Ausführungen im Zusammenhang mit dem ersten Ausführungsbeispiel verwiesen.

Der Unterschied zur Anordnung 108 besteht darin, dass die Kopplungseinrichtung 312 eine aktive Kopplungseinrichtung ist. Dies ist insbesondere dann von Vorteil, wenn selektiv auf bestimmte dynamische Betriebszustände der Anordnung 308 bzw. der Abbildungseinrichtung 101 reagiert werden soll. Die Gestaltung einer solchen aktiven Kopplungseinrichtung 312 kann grundsätzlich auf beliebige geeignete Weise realisiert sein. So können beliebige aktive Komponenten vorgesehen sein, welche die Ausgleichsbewegungen an den Stützeinheiten 310.1 und 310.2 nach beliebigen Wirkprinzipien aktiv erzeugen.

Im vorliegenden Beispiel umfasst die erste Kopplungseinheit der ersten Stützeinheit 310.1 eine erste Aktuatoreinheit 312.1, die mit einer Steuereinrichtung 312.10 verbunden ist, während die zweite Kopplungseinheit der zweiten Stützeinheiten 310.2 eine zweite Aktuatoreinheit 312.2 umfasst, die ebenfalls mit der Steuereinrichtung 312.10 verbunden ist. Auch im vorliegenden Beispiel ist die jeweilige Luftlagereinheit 111.1 bzw. 111.2 an der jeweils zugehörigen Kopplungseinheit 312.1 bzw. 312.2 über ein zugehöriges Schwenklager 112.7 bzw. 112.8 angelenkt. Demgemäß trägt die erste Aktuatoreinheit 312.1 die erste Luftlagereinheit 111.1 entlang der ersten Stützkraft FS₁₁ verschieblich, während die zweite Aktuatoreinheit 112.2 die zweite Luftlagereinheit 111.2 entlang der zweiten Stützkraft FS₁₂ verschieblich trägt. Die Steuereinrichtung 312.10 steuert dann die erste Aktuatoreinheit 312.1 und die zweite Aktuatoreinheit 312.2 zum Einstellen der ersten und zweiten Stützkraft FS₁₁ bzw. FS₁₂ an.

Um auch hier wieder das gewünschte Kräfteverhältnis V der beiden Stützkräfte FS₁₁ und FS₁₂ zu erzielen, erzeugt die Kopplungseinrichtung 312 auch im vorliegenden Beispiel eine Ausgleichsbewegung im Bereich der Luftlager 111.1 und 111.2. Für den Fall, dass dieses Kräfteverhältnis erneut V = 1 betragen soll liegt dann im Bereich der Luftlager 111.1 und 111.2 bei gleichem Lagerdruck (Luftdruck im Luftspalt) eine gleiche Spaltbreite des Luftspaltes vor.

Die Steuerung kann dabei sowohl mit als auch ohne geschlossenen Regelkreis ausgebildet sein. So kann beispielsweise vorgesehen sein, dass die erste Aktuatoreinheit 312.1 und die zweite Aktuatoreinheit 312.2 jeweils einen durch die Steuereinrichtung 312.10 angesteuerten Kraftaktuator (beispielsweise einen Lorentz-Aktuator) umfassen, der in Abhängigkeit von einem durch die Steuereinrichtung 312.10 generierten Eingangssignal eine (durch das Eingangssignal) vorgegebene Kraft erzeugt. In diesem Fall kann ein offener Regelkreis realisiert sein, mithin also einfach vorgesehen sein, dass die Steuereinrichtung 312.10 dem jeweiligen Kraftaktuator lediglich ein Eingangssignal vorgibt, anhand dessen der Kraftaktuator die gewünschte Kraft einstellt. Hierbei kann der Kraftaktuator entweder bereits unmittelbar die gewünschte Stützkraft FS₁₁ bzw. FS₁₂ an der Stützeinheit 310.1 bzw. 310.2 des Stützeinheitenpaars SEP erzeugen. Ebenso kann vorgesehen sein, dass die gewünschte Stützkraft FS₁₁ bzw. FS₁₂ erst über eine entsprechende Übersetzung zur Verfügung gestellt wird.

Bei weiteren Varianten der aktiven Kopplungseinrichtung 312 kann ein geschlossener Regelkreis vorgesehen sein. Hierzu kann beispielsweise vorgesehen sein, dass die Steuereinrichtung 312.10 mit einer ersten Erfassungseinheit 312.11 verbunden ist, die dazu konfiguriert ist, zumindest einen der ersten Kopplungseinheit 312.1 zugeordneten ersten Erfassungswert EW1 zu erfassen. Weiterhin ist die Steuereinrichtung 312.10 dann mit einer zweiten Erfassungseinheit 312.12 verbunden, die dazu konfiguriert ist, zumindest einen der zweiten Kopplungseinheit 312.2 zugeordneten zweiten Erfassungswert EW2 zu erfassen.

Der jeweilige Erfassungswert EW1 bzw. EW2 ist dabei vorzugsweise für eine Position der zugeordneten Kopplungseinheit 312.1 bzw. 312.2 entlang der Richtung der zugeordneten Stützkraft FS₁₁ bzw. FS₁₂ und/oder einen Betrag der zugeordneten Stützkraft FS₁₁ bzw. FS₁₂ und/oder einen Luftspalt der zugeordneten Luftlagereinheit 111.1 bzw. 111.2 repräsentativ. Die Steuereinrichtung 312.10 ist dann weiterhin dazu konfiguriert, in Abhängigkeit von dem ersten und zweiten Erfassungswert EW1, EW2 die erste und zweite Aktuatoreinheit 312.1 bzw. 312.2 anzusteuern, um das gewünschte Verhältnis V der beiden Stützkräfte FS₁₁ und FS₁₂ zu erzielen.

Gerade bei solchen aktiven Kopplungseinrichtungen 312 kann wiederum vorgesehen sein, dass die Stützstruktur eine Dämpfungseinrichtung 312.6 zum Dämpfen der durch die Aktuatoreinheiten 312.1 und 312.2 erzeugten Bewegungen der optischen Einheit 106 umfasst. Auch hier kann der Dämpfungswert der Dämpfungseinrichtung 312.6 wiederum verstellbar gestaltet sein. Die Dämpfungseinrichtung 312.6 kann an beliebiger geeigneter Stelle im Kraftfluss zwischen der Stützstruktur 309.1 und der optischen Einheit 106 vorgesehen sein. Insbesondere kann die Dämpfungseinrichtung 312.6 wie im vorliegenden Beispiel mit der optischen Einheit 106 verbindbar sein.

Bei bestimmten Varianten der aktiven Kopplungseinrichtung 312 kann vorgesehen sein, dass die Steuereinrichtung 312.10 die Aktuatoreinheiten 312.1 und 312.2 unter Verwendung eines Dämpfungsparameters DPM zum Dämpfen der durch die Aktuatoreinheiten 312.1 und 312.2 erzeugten Bewegungen der optischen Einheit 106 ansteuert. Auch hier kann der Dämpfungsparameter DPM insbesondere verstellbar sein.

Auch mit der vorstehend beschriebenen Gestaltung mit der aktiven Kopplungseinrichtung 312 lässt sich während des Betriebs der Abbildungseinrichtung 101 eine entsprechende bevorzugte Ausführungsform des erfindungsgemäßen Verfahrens zum Abstützen der optischen Einheit 106 realisieren, welche während des Abbildungsverfahrens zur Anwendung kommt, mit dem das Bild der Maskenstruktur der Maske 104.1 auf das Substrat 105.1 projiziert wird. Die einzelnen Verfahrensschritte ergeben sich dabei aus der obigen Beschreibung, sodass insoweit auf die obigen Ausführungen verwiesen wird.

Die vorliegende Erfindung wurde vorstehend ausschließlich anhand von Beispielen aus dem Bereich der Mikrolithographie beschrieben. Es versteht sich jedoch, dass die Erfindung auch im Zusammenhang mit beliebigen anderen optischen Anwendungen, insbesondere Abbildungsverfahren bei anderen Wellenlängen, zum Einsatz kommen kann, bei denen sich ähnliche Probleme hinsichtlich der Abstützung schwerer optischer Einheiten stellen.

Weiterhin kann die Erfindung im Zusammenhang mit der Inspektion von Objekten, wie beispielsweise der so genannten Maskeninspektion zu Einsatz kommen, bei welcher die für die Mikrolithographie verwendeten Masken auf ihre Integrität etc. untersucht werden. An Stelle des Substrats 105.1 tritt dann in Figur 1 beispielsweise eine Sensoreinheit, welche die Abbildung des Projektionsmusters der Maske 104.1 (zur weiteren Verarbeitung) erfasst. Diese Maskeninspektion kann dann sowohl im Wesentlichen bei derselben Wellenlänge erfolgen, die im späteren Mikrolithographieprozess verwendet wird. Ebenso können aber auch beliebige hiervon abweichende Wellenlängen für die Inspektion verwendet werden.

Die vorliegende Erfindung wurde vorstehend schließlich anhand konkreter Ausführungsbeispiele beschrieben, welches konkrete Kombinationen der in den nachfolgenden Patentansprüchen definierten Merkmale zeigt. Es sei an dieser Stelle ausdrücklich darauf hingewiesen, dass der Gegenstand der vorliegenden Erfindung nicht auf diese Merkmalskombinationen beschränkt ist, sondern auch sämtliche übrigen Merkmalskombinationen, wie sie sich aus den nachfolgenden Patentansprüchen ergeben, zum Gegenstand der vorliegenden Erfindung gehören.

## Patentansprüche

1. Anordnung für die Mikrolithographie, insbesondere unter Verwendung von Licht im extremen UV-Bereich (EUV), mit
- einer Stützstruktur (109; 209; 309) zum Abstützen einer optischen Einheit (106, 107), deren Masse insbesondere 4 t bis 14 t, vorzugsweise 5 t bis 10 t, weiter vorzugsweise 6 t bis 8 t, beträgt,
wobei
- die Stützstruktur (109; 209; 309) eine Anzahl von separaten Stützeinheiten (110.1, 110.2, 110.3, 110.4; 210.1, 210.2; 310.1, 310.2) zum Abstützen der optischen Einheit (106, 107) umfasst,
- jede der Stützeinheiten (110.1, 110.2, 110.3, 110.4; 210.1, 210.2; 310.1, 310.2) eine Luftlagereinheit (111.1, 111.2, 111.3, 111.4) umfasst, über welche eine Stützkraft erzeugbar ist, welche der Gewichtskraft der optischen Einheit (106, 107) entgegenwirkt,
- die Anzahl der Stützeinheiten (110.1, 110.2, 110.3, 110.4; 210.1, 210.2; 310.1, 310.2) wenigstens vier beträgt, **dadurch gekennzeichnet, dass**
- wenigstens zwei der Stützeinheiten (110.1, 110.2, 110.3, 110.4; 210.1, 210.2; 310.1, 310.2) derart über eine Kopplungseinrichtung (112; 212; 312) zu einem Stützeinheitenpaar gekoppelt sind, dass die Kopplungseinrichtung (112; 212; 312) einer Abweichung von einem vorgebbaren Verhältnis der Stützkräfte der beiden Stützeinheiten (110.1, 110.2; 210.1, 210.2; 310.1, 310.2) des Stützeinheitenpaars entgegenwirkt.

2. Anordnung nach Anspruch 1, wobei
- das vorgebbare Verhältnis der Stützkräfte 1/3 bis 1/1, vorzugsweise 1/2 bis 1/1, weiter vorzugsweise 2/3 bis 1/1, beträgt
und/oder
- die Kopplungseinrichtung (112; 212; 312) dazu konfiguriert ist, den Betrag der Stützkräfte der beiden Stützeinheiten (110.1, 110.2; 210.1, 210.2; 310.1, 310.2) des Stützeinheitenpaars zumindest im Wesentlichen zu egalisieren,
und/oder
- die Kopplungseinrichtung (112; 212; 312) dazu konfiguriert ist, dass eine Abweichung zwischen den Beträgen der Stützkräfte der beiden Stützeinheiten (110.1, 110.2; 210.1, 210.2; 310.1, 310.2) zu minimieren.

3. Anordnung nach Anspruch 1 oder 2, wobei
- eine erste Stützeinheit (110.1; 210.1; 310.1) des Stützeinheitenpaars dazu konfiguriert ist, eine erste Stützkraft auszuüben,
- eine zweite Stützeinheit (110.2; 210.2; 310.2) des Stützeinheitenpaars dazu konfiguriert ist, eine zweite Stützkraft auszuüben, und
- die Kopplungseinrichtung (112; 212; 312) derart konfiguriert ist, dass der Betrag der ersten Stützkraft um weniger als 1,0%, vorzugsweise weniger als 0,5%, weiter vorzugsweise um weniger als 0,1%, von dem Betrag der zweiten Stützkraft abweicht.

4. Anordnung nach einem der Ansprüche 1 bis 3, wobei
- eine erste Stützeinheit (110.1; 210.1; 310.1) des Stützeinheitenpaars eine erste Luftlagereinheit (111.1) zum Erzeugen einer ersten Stützkraft aufweist,
- eine zweite Stützeinheit (110.2; 210.2; 310.2) des Stützeinheitenpaars eine zweite Luftlagereinheit (111.2) zum Erzeugen einer zweiten Stützkraft aufweist,
- die Kopplungseinrichtung (112; 212; 312) eine erste Kopplungseinheit (112.1; 212.1; 312.1) aufweist, welche die erste Luftlagereinheit (111.1) zumindest entlang der ersten Stützkraft verschieblich trägt,
- die Kopplungseinrichtung (112; 212; 312) eine zweite Kopplungseinheit (112.2; 212.2; 312.2) aufweist, welche die zweite Luftlagereinheit (111.2) zumindest entlang der zweiten Stützkraft verschieblich trägt, und
- die erste Kopplungseinheit (112.1; 212.1; 312.1) und die zweite Kopplungseinheit (112.2; 212.2; 312.2) derart miteinander gekoppelt sind, dass eine erste Verschiebung entlang der ersten Stützkraft an der erste Luftlagereinheit (111.1) eine gegenläufige zweite Verschiebung entlang der zweiten Stützkraft an der zweiten Luftlagereinheit (111.2) bewirkt,
wobei insbesondere
- der Betrag der ersten Verschiebung zumindest im Wesentlichen gleich dem Betrag der zweiten Verschiebung ist,
und/oder
- die jeweilige Kopplungseinheit (112.1, 112.2; 212.1, 212.2; 312.1, 312.2) über ein Schwenklager (112.7, 112.8) mit der zugehörigen Luftlagereinheit (111.1, 111.2) verbunden ist, wobei insbesondere eines der beiden Schwenklager (112.7, 112.8) genau drei translatorische Freiheitsgrade einschränkt und das andere der beiden Schwenklager (112.7, 112.8) genau einen translatorischen Freiheitsgrad einschränkt.

5. Anordnung nach Anspruch 4, wobei
- die Kopplungseinrichtung eine hydraulische Kopplungseinrichtung (112) ist, wobei insbesondere
- die erste Kopplungseinheit (112.1) eine erste Kolben-Zylinder-Einheit mit einem ersten hydraulischen Arbeitsraum (112.3) ist,
- die zweite Kopplungseinheit (112.2) eine zweite Kolben-Zylinder-Einheit mit einem zweiten hydraulischen Arbeitsraum (112.4) ist und
- der erste hydraulische Arbeitsraum (112.3) und der zweite hydraulische Arbeitsraum (112.4) hydraulisch miteinander gekoppelt sind,
wobei insbesondere wenigstens eines von Nachfolgendem gilt:
- die beiden Kolben-Zylinder-Einheiten (112.1, 112.2) weisen eine zumindest im Wesentlichen identische effektive Kolbenfläche auf,
- der erste hydraulische Arbeitsraum (112.3) und der zweite hydraulische Arbeitsraum (112.4) sind über wenigstens eine Hydraulikleitung (112.5) miteinander gekoppelt,
- eine Drosseleinrichtung (112.6) ist zwischen dem ersten und zweiten hydraulischen Arbeitsraum (112.3, 112.4) vorgesehen, wobei die Drosselung durch die Drosseleinrichtung (112.6) insbesondere verstellbar ist.
- die Kopplungseinrichtung (112) umfasst eine Pumpeinrichtung zum aktiven Befüllen des ersten und zweiten hydraulischen Arbeitsraums (112.3, 112.4).

6. Anordnung nach Anspruch 4, wobei
- die Kopplungseinrichtung eine mechanische Kopplungseinrichtung (212) ist, wobei insbesondere
- die erste Kopplungseinheit (212.1) ein erster Arm einer Wippeneinheit (212.5) ist,
- die zweite Kopplungseinheit (212.2) ein zweiter Arm der Wippeneinheit (212.5) ist und
- der erste Arm (212.1) und der zweite Arm (212.2) im Bereich eines Schwenklagers (212.9) der Wippeneinheit (212.5) miteinander verbunden sind,
wobei insbesondere wenigstens eines von Nachfolgendem gilt:
- der erste Arm (212.1) und der zweite Arm (212.2) sind miteinander einstückig ausgebildet,
- das Schwenklager (212.9) der Wippeneinheit (212.5) schränkt drei translatorische Freiheitsgrade und zwei rotatorische Freiheitsgrade ein,
- das Schwenklager (212.9) der Wippeneinheit (212.5) ist im Bereich einer Verbindungslinie der Schwenklager (112.7, 112.8) der Kopplungseinheiten (212.1, 212.2) angeordnet, wobei insbesondere eine Schwenkachse des Schwenklagers (212.9) der Wippeneinheit (212.5) die Verbindungslinie schneidet,
- die Wippeneinheit (212.5) umfasst eine Dämpfungseinrichtung (212.6) zum Dämpfen der Schwenkbewegung um das Schwenklager (212.9) der Wippeneinheit (212.5), wobei der Dämpfungswert der Dämpfungseinrichtung (212.6) insbesondere verstellbar ist.

7. Anordnung nach Anspruch 4, wobei
- die Kopplungseinrichtung eine aktive Kopplungseinrichtung (312) ist, wobei insbesondere
- die erste Kopplungseinheit (312.1) eine erste Aktuatoreinheit umfasst, die mit einer Steuereinrichtung (312.10) verbunden ist,
- die zweite Kopplungseinheit (312.2) eine zweite Aktuatoreinheit umfasst, die mit der Steuereinrichtung (312.10) verbunden ist, und
- die Steuereinrichtung (312.10) die erste und die zweite Aktuatoreinheit (312.1, 312.2) zum Einstellen der ersten und zweiten Stützkraft ansteuert.
wobei insbesondere wenigstens eines von Nachfolgendem gilt:
- die erste Aktuatoreinheit (312.1) und die zweite Aktuatoreinheit (312.2) umfasst jeweils einen durch die Steuereinrichtung (312.10) angesteuerten Kraftaktuator,
- die Stützstruktur (309) umfasst eine Dämpfungseinrichtung (312.6) zum Dämpfen der durch die Aktuatoreinheiten (312.1, 312.2) erzeugten Bewegungen der optischen Einheit (106, 107), wobei der Dämpfungswert der Dämpfungseinrichtung (312.6) insbesondere verstellbar ist und/oder die Dämpfungseinrichtung (312.6) insbesondere mit der optischen Einheit (106, 107) verbindbar ist,
- die Steuereinrichtung (312.10) steuert die Aktuatoreinheiten (312.1, 312.2) unter Verwendung eines Dämpfungsparameters zum Dämpfen der durch die Aktuatoreinheiten (312.1, 312.2) erzeugten Bewegungen der optischen Einheit (106, 107) an, wobei der Dämpfungsparameter insbesondere verstellbar ist.

8. Anordnung nach Anspruch 7, wobei
- die Steuereinrichtung (312.10) mit einer ersten Erfassungseinheit (312.11) verbunden ist, die dazu konfiguriert ist, zumindest einen der ersten Kopplungseinheit (312.1) zugeordneten ersten Erfassungswert zu erfassen,
- die Steuereinrichtung (312.10) mit einer zweiten Erfassungseinheit (312.12) verbunden ist, die dazu konfiguriert ist, zumindest einen der zweiten Kopplungseinheit (312.2) zugeordneten zweiten Erfassungswert zu erfassen,
- der jeweilige Erfassungswert für eine Position der zugeordneten Kopplungseinheit (312.1, 312.2) entlang der Richtung der zugeordneten Stützkraft und/oder einen Betrag der zugeordneten Stützkraft und/oder einen Luftspalt der zugeordneten Luftlagereinheit (111.1, 111.2) repräsentativ ist,
- die Steuereinrichtung (312.10) dazu konfiguriert ist, in Abhängigkeit von dem ersten und zweiten Erfassungswert die erste und zweite Aktuatoreinheit (312.1, 312.2) anzusteuern.

9. Anordnung nach einem der Ansprüche 1 bis 8, wobei
- die optische Einheit (106, 107) einen Schwerpunkt aufweist,
- die Gewichtskraft der optischen Einheit (106, 107) und die Stützkräfte der Stützeinheiten (110.1, 110.2, 110.3, 110.4; 210.1, 210.2; 310.1, 310.2) eine Horizontalebene jeweils in einem Kraftschnittpunkt schneiden und
- wenigstens die Stützeinheit (110.1; 210.1; 310.1), deren Kraftschnittpunkt in der Horizontalebene den geringsten Abstand zu dem Kraftschnittpunkt der Gewichtskraft aufweist, eine der beiden Stützeinheiten (110.1, 110.2; 210.1, 210.2; 310.1, 310.2) des wenigstens einen Stützeinheitenpaars bildet,
wobei insbesondere
- die Stützeinheit (110.2; 210.2; 310.2), deren Kraftschnittpunkt in der Horizontalebene den zweitgeringsten Abstand zu dem Kraftschnittpunkt der Gewichtskraft aufweist, die andere der beiden Stützeinheiten (110.1, 110.2; 210.1, 210.2; 310.1, 310.2) des wenigstens einen Stützeinheitenpaars bildet.
und/oder
- die optische Einheit (106, 107) in der Horizontalebene eine Umfangsrichtung definiert und die Kraftschnittpunkte der beiden Stützeinheiten (110.1, 110.2; 210.1, 210.2; 310.1, 310.2) des wenigstens einen Stützeinheitenpaars in der Umfangsrichtung unmittelbar zueinander benachbart sind.

10. Anordnung nach einem der Ansprüche 1 bis 9, wobei
- die Anzahl der Stützeinheiten (110.1, 110.2, 110.3, 110.4; 210.1, 210.2; 310.1, 310.2) genau vier beträgt
oder
- die Anzahl der Stützeinheiten (110.1, 110.2, 110.3, 110.4; 210.1, 210.2; 310.1, 310.2) wenigstens fünf, insbesondere genau fünf, beträgt und ein von dem Stützeinheitenpaar separates weiteres Stützeinheitenpaar vorgesehen ist,
oder
- die Anzahl der Stützeinheiten (110.1, 110.2, 110.3, 110.4; 210.1, 210.2; 310.1, 310.2) genau sechs beträgt und zwei von dem Stützeinheitenpaar und voneinander separate weitere Stützeinheitenpaare vorgesehen sind.

11. Optische Abbildungseinrichtung, insbesondere für die Mikrolithographie, mit
- einer Beleuchtungseinrichtung (102) mit einer ersten optischen Elementgruppe (106),
- einer Objekteinrichtung (104) zur Aufnahme eines Objekts (104.1),
- einer Projektionseinrichtung (103) mit einer zweiten optischen Elementgruppe (107) und
- einer Bildeinrichtung (105), wobei
- die Beleuchtungseinrichtung (102) zur Beleuchtung des Objekts (104.1) ausgebildet ist und
- die Projektionseinrichtung (103) zur Projektion einer Abbildung des Objekts (103.1) auf die Bildeinrichtung (105) ausgebildet ist,
**dadurch gekennzeichnet, dass**
- die Beleuchtungseinrichtung (102) und/oder die Projektionseinrichtung (103) wenigstens eine Anordnung nach einem der Ansprüche 1 bis 10 umfasst.

12. Verfahren zum Abstützen einer optischen Einheit (106, 107) für die Mikrolithographie, insbesondere unter Verwendung von Licht im extremen UV-Bereich (EUV) mittels einer Stützstruktur (109; 209; 309), wobei
- die optische Einheit (106, 107) mittels einer Anzahl von separaten Stützeinheiten (110.1, 110.2, 110.3, 110.4; 210.1, 210.2; 310.1, 310.2) der Stützstruktur (109; 209; 309) abgestützt wird, indem jede der Stützeinheiten (110.1, 110.2, 110.3, 110.4; 210.1, 210.2; 310.1, 310.2) über eine Luftlagereinheit (111.1, 111.2, 111.3, 111.4) eine Stützkraft erzeugt, welche der Gewichtskraft der optischen Einheit (106, 107) entgegenwirkt, wobei die Masse der optischen Einheit (106, 107) insbesondere 4 t bis 14 t, vorzugsweise 5 t bis 10 t, weiter vorzugsweise 6 t bis 8 t, beträgt,
- die Anzahl der Stützeinheiten (110.1, 110.2, 110.3, 110.4; 210.1, 210.2; 310.1, 310.2) wenigstens vier beträgt, **dadurch gekennzeichnet, dass**
- wenigstens zwei der Stützeinheiten (110.1, 110.2, 110.3, 110.4; 210.1, 210.2; 310.1, 310.2) derart über eine Kopplungseinrichtung (112; 212; 312) zu einem Stützeinheitenpaar gekoppelt werden, dass die Kopplungseinrichtung (112; 212; 312) einer Abweichung von einem vorgebbaren Verhältnis der beiden Stützkräften der beiden Stützeinheiten (110.1, 110.2; 210.1, 210.2; 310.1, 310.2) des Stützeinheitenpaars entgegenwirkt.

13. Verfahren nach Anspruch 12, wobei wenigstens eines von Nachfolgendem gilt:
- das vorgebbare Verhältnis der Stützkräfte beträgt 1/3 bis 1/1, vorzugsweise 1/2 bis 1/1, weiter vorzugsweise 2/3 bis 1/1,
- die Kopplungseinrichtung (112; 212; 312) egalisiert den Betrag der Stützkräfte der beiden Stützeinheiten (110.1, 110.2; 210.1, 210.2; 310.1, 310.2) des Stützeinheitenpaars zumindest im Wesentlichen,
- die Kopplungseinrichtung (112; 212; 312) minimiert eine Abweichung zwischen den Beträgen der Stützkräfte der beiden Stützeinheiten (110.1, 110.2; 210.1, 210.2; 310.1, 310.2),
- eine erste Stützeinheit (110.1; 210.1; 310.1) des Stützeinheitenpaars übt eine erste Stützkraft aus, eine zweite Stützeinheit (110.2; 210.2; 310.2) des Stützeinheitenpaars übt eine zweite Stützkraft aus, und die die erste Stützkraft und die zweite Stützkraft werden über die Kopplungseinrichtung (112; 212; 312) derart eingestellt, dass der Betrag der ersten Stützkraft um weniger als 1,0%, vorzugsweise weniger als 0,5%, weiter vorzugsweise um weniger als 0,1%, (106, 107) von dem Betrag der zweiten Stützkraft abweicht,

14. Verfahren nach einem der Ansprüche 12 bis 13, wobei
- eine erste Stützeinheit (110.1; 210.1; 310.1) des Stützeinheitenpaars eine erste Luftlagereinheit (111.1) zum Erzeugen einer ersten Stützkraft aufweist,
- eine zweite Stützeinheit (110.2; 210.2; 310.2) des Stützeinheitenpaars eine zweite Luftlagereinheit (111.2) zum Erzeugen einer zweiten Stützkraft aufweist,
- die Kopplungseinrichtung (112; 212; 312) eine erste Kopplungseinheit (112.1; 212.1; 312.1) aufweist, welche die erste Luftlagereinheit (111.1) zumindest entlang der ersten Stützkraft verschieblich trägt,
- die Kopplungseinrichtung (112; 212; 312) eine zweite Kopplungseinheit aufweist, welche die zweite Luftlagereinheit (111.2) zumindest entlang der zweiten Stützkraft verschieblich trägt, und
- die erste Kopplungseinheit (112.1; 212.1; 312.1) und die zweite Kopplungseinheit derart miteinander gekoppelt werden, dass eine erste Verschiebung entlang der ersten Stützkraft an der erste Luftlagereinheit (111.1) eine gegenläufige zweite Verschiebung entlang der zweiten Stützkraft an der zweiten Luftlagereinheit (111.2) bewirkt,
wobei insbesondere wenigstens eines von Nachfolgendem gilt:
- der Betrag der ersten Verschiebung ist zumindest im Wesentlichen gleich dem Betrag der zweiten Verschiebung,
- die jeweilige Kopplungseinheit (112.1, 112.2; 212.1, 212.2; 312.1, 312.2) über ein Schwenklager (112.7, 112.8) mit der zugehörigen Luftlagereinheit (111.1, 111.2) verbunden ist, wobei insbesondere eines der beiden Schwenklager (112.7, 112.8) genau drei translatorische Freiheitsgrade einschränkt und das andere der beiden Schwenklager (112.7, 112.8) genau einen translatorischen Freiheitsgrad einschränkt.
- die erste Kopplungseinheit (112.1) und die zweite Kopplungseinheit (112.2) werden hydraulisch gekoppelt,
- die erste Kopplungseinheit (212.1) und die zweite Kopplungseinheit (212.2) werden mechanisch, insbesondere über eine Wippeneinheit (212.5), gekoppelt,
- die erste Kopplungseinheit (312.1) und die zweite Kopplungseinheit (312.2) werden aktiv gekoppelt,
- es erfolgt eine Dämpfung der mittels der Kopplungseinrichtung (112; 212; 312) erzeugten Bewegungen der optischen Einheit (106, 107), wobei der Dämpfungswert der Dämpfung insbesondere verstellbar ist,
- die erste Kopplungseinheit (312.1) eine erste Aktuatoreinheit umfasst und die zweite Kopplungseinheit (312.2) eine zweite Aktuatoreinheit umfasst, wobei
- zumindest einen der ersten Kopplungseinheit (312.1) zugeordneter erster Erfassungswert erfasst wird, zumindest einen der zweiten Kopplungseinheit (312.2) zugeordneter zweiter Erfassungswert erfasst wird, der jeweilige Erfassungswert für eine Position der zugeordneten Kopplungseinheit (312.1, 312.2) entlang der Richtung der zugeordneten Stützkraft und/oder einen Betrag der zugeordneten Stützkraft und/oder einen Luftspalt der zugeordneten Luftlagereinheit (111.1, 111.2) repräsentativ ist, in Abhängigkeit von dem ersten und zweiten Erfassungswert die erste und zweite Aktuatoreinheit (312.1, 312.2) angesteuert wird.

15. Optisches Abbildungsverfahren, insbesondere für die Mikrolithographie, bei dem
- über eine Beleuchtungseinrichtung (102) mit einer ersten optischen Elementgruppe (106) ein Objekt (104.1) beleuchtet wird und
- mittels einer Projektionseinrichtung (103) mit einer zweiten optischen Elementgruppe (107) eine Abbildung des Objekts (104.1) auf einer Bildeinrichtung (105) erzeugt wird,
**dadurch gekennzeichnet, dass**
- in der Beleuchtungseinrichtung (102) und/oder der Projektionseinrichtung (103), insbesondere während des Erzeugens der Abbildung, ein Verfahren nach einem der Ansprüche 12 bis 14 verwendet wird.

## Claims

1. Microlithographic arrangement, in particular using light in the extreme UV range (EUV), with
- a supporting structure (109; 209; 309) for supporting an optical unit (106, 107), the mass of which is in particular 4 t to 14 t, preferably 5 t to 10 t, more preferably 6 t to 8 t,
wherein
- the supporting structure (109; 209; 309) comprises a number of separate supporting units (110.1, 110.2, 110.3, 110.4; 210.1, 210.2; 310.1, 310.2) for supporting the optical unit (106, 107),
- each of the supporting units (110.1, 110.2, 110.3, 110.4; 210.1, 210.2; 310.1, 310.2) comprises an air bearing unit (111.1, 111.2, 111.3, 111.4), by way of which a supporting force which counteracts the weight of the optical unit (106, 107) can be generated,
- the number of supporting units (110.1, 110.2, 110.3, 110.4; 210.1, 210.2; 310.1, 310.2) is at least four, **characterized in that**
- at least two of the supporting units (110.1, 110.2, 110.3, 110.4; 210.1, 210.2; 310.1, 310.2) are coupled by way of a coupling device (112; 212; 312) to form a pair of supporting units in such a way that the coupling device (112; 212; 312) counteracts a deviation from a predeterminable ratio of the supporting forces of the two supporting units (110.1, 110.2; 210.1, 210.2; 310.1, 310.2) of the pair of supporting units.

2. Arrangement according to Claim 1, wherein
- the predeterminable ratio of the supporting forces is 1/3 to 1/1, preferably 1/2 to 1/1, more preferably 2/3 to 1/1,
and/or
- the coupling device (112; 212; 312) is configured to at least substantially equalize the amount of the supporting forces of the two supporting units (110.1, 110.2; 210.1, 210.2; 310.1, 310.2) of the pair of supporting units,
and/or
- the coupling device (112; 212; 312) is configured to minimize a deviation between the amounts of the supporting forces of the two supporting units (110.1, 110.2; 210.1, 210.2; 310.1, 310.2).

3. Arrangement according to Claim 1 or 2, wherein
- a first supporting unit (110.1; 210.1; 310.1) of the pair of supporting units is configured to exert a first supporting force,
- a second supporting unit (110.2; 210.2; 310.2) of the pair of supporting units is configured to exert a second supporting force, and
- the coupling device (112; 212; 312) is configured in such a way that the amount of the first supporting force deviates by less than 1.0%, preferably less than 0.5%, more preferably by less than 0.1%, from the amount of the second supporting force.

4. Arrangement according to one of Claims 1 to 3, wherein
- a first supporting unit (110.1; 210.1; 310.1) of the pair of supporting units has a first air bearing unit (111.1) for generating a first supporting force,
- a second supporting unit (110.2; 210.2; 310.2) of the pair of supporting units has a second air bearing unit (111.2) for generating a second supporting force,
- the coupling device (112; 212; 312) has a first coupling unit (112.1; 212.1; 312.1), which carries the first air bearing unit (111.1) displaceably at least along the first supporting force,
- the coupling device (112; 212; 312) has a second coupling unit (112.2; 212.2; 312.2), which carries the second air bearing unit (111.2) displaceably at least along the second supporting force, and
- the first coupling unit (112.1; 212.1; 312.1) and the second coupling unit (112.2; 212.2; 312.2) are coupled to one another in such a way that a first displacement along the first supporting force on the first air bearing unit (111.1) brings about an opposite second displacement along the second supporting force on the second air bearing unit (111.2),
wherein in particular
- the amount of the first displacement is at least substantially equal to the amount of the second displacement,
and/or
- the respective coupling unit (112.1, 112.2; 212.1, 212.2; 312.1, 312.2) is connected to the associated air bearing unit (111.1, 111.2) by way of a pivot bearing (112.7, 112.8), in particular one of the two pivot bearings (112.7, 112.8) restricting exactly three translational degrees of freedom and the other of the two pivot bearings (112.7, 112.8) restricting exactly one translational degree of freedom.

5. Arrangement according to Claim 4, wherein
- the coupling device is a hydraulic coupling device (112),
wherein in particular
- the first coupling unit (112.1) is a first piston-cylinder unit with a first hydraulic working space (112.3),
- the second coupling unit (112.2) is a second piston-cylinder unit with a second hydraulic working space (112.4) and
- the first hydraulic working space (112.3) and the second hydraulic working space (112.4) are hydraulically coupled to one another,
wherein in particular at least one of the following applies:
- the two piston-cylinder units (112.1, 112.2) have an at least substantially identical effective piston area
- the first hydraulic working space (112.3) and the second hydraulic working space (112.4) are coupled to one another by way of at least one hydraulic line (112.5)
- a throttle device (112.6) is provided between the first and second hydraulic working spaces (112.3, 112.4), the throttling being in particular adjustable by the throttle device (112.6),
- the coupling device (112) comprises a pumping device for actively filling the first and second hydraulic working spaces (112.3, 112.4).

6. Arrangement according to Claim 4, wherein
- the coupling device is a mechanical coupling device (212),
wherein in particular
- the first coupling unit (212.1) is a first arm of a rocker unit (212.5),
- the second coupling unit (212.2) is a second arm of the rocker unit (212.5) and
- the first arm (212.1) and the second arm (212.2) are connected to one another in the region of a pivot bearing (212.9) of the rocker unit (212.5), wherein in particular at least one of the following applies:
- the first arm (212.1) and the second arm (212.2) are formed in one piece with one another
- the pivot bearing (212.9) of the rocker unit (212.5) restricts three translational degrees of freedom and two rotational degrees of freedom
- the pivot bearing (212.9) of the rocker unit (212.5) is arranged in the region of a connecting line of the pivot bearings (112.7, 112.8) of the coupling units (212.1, 212.2), in particular a pivot axis of the pivot bearing (212.9) of the rocker unit (212.5) intersecting the connecting line,
- the rocker unit (212.5) comprises a damping device (212.6) for damping the pivoting movement about the pivot bearing (212.9) of the rocker unit (212.5), the damping value of the damping device (212.6) in particular being adjustable.

7. Arrangement according to Claim 4, wherein
- the coupling device is an active coupling device (312),
wherein in particular
- the first coupling unit (312.1) comprises a first actuator unit, which is connected to a control device (312.10),
- the second coupling unit (312.2) comprises a second actuator unit, which is connected to the control device (312.10), and
- the control device (312.10) controls the first and the second actuator unit (312.1, 312.2) for setting the first and second supporting forces, wherein in particular at least one of the following applies:
- the first actuator unit (312.1) and the second actuator unit (312.2) respectively comprises a force actuator controlled by the control device (312.10)
- the supporting structure (309) comprises in particular a damping device (312.6) for damping the movements of the optical unit (106, 107) generated by the actuator units (312.1, 312.2), the damping value of the damping device (312.6) in particular being adjustable and/or the damping device (312.6) in particular being connectable to the optical unit (106, 107),
- the control device (312.10) controls the actuator units (312.1, 312.2) using a damping parameter for damping the movements of the optical unit (106, 107) generated by the actuator units (312.1, 312.2), the damping parameter in particular being adjustable.

8. Arrangement according to Claim 7, wherein
- the control device (312.10) is connected to a first detection unit (312.11), which is configured to detect at least one first detection value assigned to the first coupling unit (312.1),
- the control device (312.10) is connected to a second detection unit (312.12), which is configured to detect at least one second detection value assigned to the second coupling unit (312.2),
- the respective detection value is representative of a position of the assigned coupling unit (312.1, 312.2) along the direction of the assigned supporting force and/or an amount of the assigned supporting force and/or an air gap of the assigned air bearing unit (111.1, 111.2),
- the control device (312.10) is configured to control the first and second actuator units (312.1, 312.2) in dependence on the first and second detection values.

9. Arrangement according to one of Claims 1 to 8, wherein
- the optical unit (106, 107) has a centre of gravity,
- the weight of the optical unit (106, 107) and the supporting forces of the supporting units (110.1, 110.2, 110.3, 110.4; 210.1, 210.2; 310.1, 310.2) respectively intersect a horizontal plane at a force intersection and
- at least the supporting unit (110.1; 210.1; 310.1) whose force intersection in the horizontal plane is at the smallest distance from the force intersection of the weight, forms one of the two supporting units (110.1, 110.2; 210.1, 210.2; 310.1, 310.2) of the at least one pair of supporting units,
wherein in particular
- the supporting unit (110.2; 210.2; 310.2) whose force intersection in the horizontal plane is at the second smallest distance from the force intersection of the weight forms the other of the two supporting units (110.1, 110.2; 210.1, 210.2; 310.1, 310.2) of the at least one pair of supporting units
and/or
- the optical unit (106, 107) defines a circumferential direction in the horizontal plane and the force intersections of the two supporting units (110.1, 110.2; 210.1, 210.2; 310.1, 310.2) of the at least one pair of supporting units are directly adjacent to one another in the circumferential direction.

10. Arrangement according to one of Claims 1 to 9, wherein
- the number of supporting units (110.1, 110.2, 110.3, 110.4; 210.1, 210.2; 310.1, 310.2) is exactly four
or
- the number of supporting units (110.1, 110.2, 110.3, 110.4; 210.1, 210.2; 310.1, 310.2) is at least five, in particular exactly five, and a further pair of supporting units separate from the pair of supporting units is provided,
or
- the number of supporting units (110.1, 110.2, 110.3, 110.4; 210.1, 210.2; 310.1, 310.2) is exactly six and two further pairs of supporting units separate from the pair of supporting units and from one another are provided.

11. Optical imaging device, in particular for microlithography, with
- an illumination device (102) with a first optical element group (106),
- an object device (104) for receiving an object (104.1),
- a projection device (103) with a second optical element group (107) and
- an image device (105), wherein
- the illumination device (102) is designed to illuminate the object (104.1) and
- the projection device (103) is designed to project an image of the object (103.1) onto the image device (105),
**characterized in that**
- the illumination device (102) and/or the projection device (103) comprises at least one arrangement according to one of claims 1 to 10.

12. Method for supporting a microlithographic optical unit (106, 107), in particular using light in the extreme UV range (EUV), by means of a supporting structure (109; 209; 309),
- the optical unit (106, 107) is supported by means of a number of separate supporting units (110.1, 110.2, 110.3, 110.4; 210.1, 210.2; 310.1, 310.2) of the supporting structure (109; 209; 309) by each of the supporting units (110.1 , 110.2, 110.3, 110.4; 210.1, 210.2; 310.1, 310.2) generating by way of an air bearing unit (111.1, 111.2, 111.3, 111.4) a supporting force which counteracts the weight of the optical unit (106, 107), the mass of the optical unit (106, 107) being in particular 4 t to 14 t, preferably 5 t to 10 t, more preferably 6 t to 8 t,
- the number of supporting units (110.1, 110.2, 110.3, 110.4; 210.1, 210.2; 310.1, 310.2) is at least four, **characterized in that**
- at least two of the supporting units (110.1, 110.2, 110.3, 110.4; 210.1, 210.2; 310.1, 310.2) are coupled by way of a coupling device (112; 212; 312) to form a pair of supporting units in such a way that the coupling device (112; 212; 312) counteracts a deviation from a predeterminable ratio of the two supporting forces of the two supporting units (110.1, 110.2; 210.1, 210.2; 310.1, 310.2) of the pair of supporting units.

13. Method according to Claim 12, wherein at least one of the following applies:
- the predeterminable ratio of the supporting forces is 1/3 to 1/1, preferably 1/2 to 1/1, more preferably 2/3 to 1/1,
- the coupling device (112; 212; 312) at least substantially equalizes the amount of the supporting forces of the two supporting units (110.1, 110.2; 210.1, 210.2; 310.1, 310.2) of the pair of supporting units,
- the coupling device (112; 212; 312) minimizes a deviation between the amounts of the supporting forces of the two supporting units (110.1, 110.2; 210.1, 210.2; 310.1, 310.2).
- a first supporting unit (110.1; 210.1; 310.1) of the pair of supporting units exerts a first supporting force, a second supporting unit (110.2; 210.2; 310.2) of the pair of supporting units exerts a second supporting force, and the first supporting force and the second supporting force are set by way of the coupling device (112; 212; 312) in such a way that the amount of the first supporting force deviates by less than 1.0%, preferably less than 0.5%, more preferably by less than 0.1%, (106, 107) from the amount of the second supporting force.

14. Method according to either of Claims 13 and 14, wherein
- a first supporting unit (110.1; 210.1; 310.1) of the pair of supporting units has a first air bearing unit (111.1) for generating a first supporting force,
- a second supporting unit (110.2; 210.2; 310.2) of the pair of supporting units has a second air bearing unit (111.2) for generating a second supporting force,
- the coupling device (112; 212; 312) has a first coupling unit (112.1; 212.1; 312.1), which carries the first air bearing unit (111.1) displaceably at least along the first supporting force,
- the coupling device (112; 212; 312) has a second coupling unit, which carries the second air bearing unit (111.2) displaceably at least along the second supporting force, and
- the first coupling unit (112.1; 212.1; 312.1) and the second coupling unit are coupled to one another in such a way that a first displacement along the first supporting force on the first air bearing unit (111.1) brings about an opposite second displacement along the second supporting force on the second air bearing unit (111.2), wherein in particular at least one of the following applies:
- the amount of the first displacement is at least substantially equal to the amount of the second displacement,
- the respective coupling unit (112.1, 112.2; 212.1, 212.2; 312.1, 312.2) is connected to the associated air bearing unit (111.1, 111.2) by way of a pivot bearing (112.7, 112.8), in particular one of the two pivot bearings (112.7, 112.8) restricting exactly three translational degrees of freedom and the other of the two pivot bearings (112.7, 112.8) restricting exactly one translational degree of freedom.
- the first coupling unit (112.1) and the second coupling unit (112.2) are hydraulically coupled
- the first coupling unit (212.1) and the second coupling unit (212.2) are mechanically coupled, in particular by way of a rocker unit (212.5),
- the first coupling unit (312.1) and the second coupling unit (312.2) are actively coupled,
- a damping of the movements of the optical unit (106, 107) generated by means of the coupling device (112; 212; 312) takes place, the damping value of the damping device in particular being adjustable,
- the first coupling unit (312.1) comprises a first actuator unit and the second coupling unit (312.2) comprises a second actuator unit, wherein
- at least one first detection value assigned to the first coupling unit (312.1) is detected, at least one second detection value assigned to the second coupling unit (312.2) is detected, the respective detection value is representative of a position of the assigned coupling unit (312.1, 312.2) along the direction of the assigned supporting force and/or an amount of the assigned supporting force and/or an air gap of the assigned air bearing unit (111.1, 111.2), the first and second actuator units (312.1, 312.2) are controlled in dependence on the first and second detection values.

15. Optical imaging method, in particular for microlithography, in which
- an object (104.1) is illuminated by way of an illumination device (102) with a first optical element group (106) and
- an image of the object (104.1) is generated on an image device (105) by means of a projection device (103) with a second optical element group (107),
**characterized in that**
- a method according to one of claims 12 to 14 is used in the illumination device (102) and/or the projection device (103), in particular during the generation of the image.

## Revendications

1. Agencement de microlithographie, en particulier en utilisant de la lumière dans le domaine ultraviolet extrême (EUV), comprenant
- une structure de soutien (109 ; 209 ; 309) servant à soutenir une unité optique (106, 107) dont la masse va en particulier de 4 t à 14 t, de préférence de 5 t à 10 t, de plus grande préférence de 6 t à 8 t, dans lequel
- la structure de soutien (109 ; 209 ; 309) comprend un nombre d'unités de soutien séparées (110.1, 110.2, 110.3, 110.4 ; 210.1, 210.2 ; 310.1, 310.2) servant à soutenir l'unité optique (106, 107),
- chacune des unités de soutien (110.1, 110.2, 110.3, 110.4 ; 210.1, 210.2 ; 310.1, 310.2) comprend une unité de palier pneumatique (111.1, 111.2, 111.3, 111.4) qui permet de générer une force de soutien qui s'oppose au poids de l'unité optique (106, 107),
- le nombre des unités de soutien (110.1, 110.2, 110.3, 110.4 ; 210.1, 210.2 ; 310.1, 310.2) s'élève au moins à quatre,
**caractérisé en ce que**
- au moins deux des unités de soutien (110.1, 110.2, 110.3, 110.4 ; 210.1, 210.2 ; 310.1, 310.2) sont couplées en une paire d'unités de soutien par l'intermédiaire d'un dispositif de couplage (112 ; 212 ; 312) de telle sorte que le dispositif de couplage (112; 212; 312) s'oppose à un écart d'un rapport prédéfinissable des forces de soutien des deux unités de soutien (110.1, 110.2 ; 210.1, 210.2 ; 310.1, 310.2) de la paire d'unités de soutien.

2. Agencement selon la revendication 1, dans lequel
- le rapport prédéfinissable des forces de soutien va de 1/3 à 1/1, de préférence de 1/2 à 1/1, de plus grande préférence de 2/3 à 1/1,
et/ou
- le dispositif de couplage (112 ; 212 ; 312) est configuré pour égaliser au moins substantiellement la grandeur des forces de soutien des deux unités de soutien (110.1, 110.2 ; 210.1, 210.2 ; 310.1, 310.2) de la paire d'unités de soutien,
et/ou
- le dispositif de couplage (112 ; 212 ; 312) est configuré pour minimiser un écart entre les grandeurs des forces de soutien des deux unités de soutien (110.1, 110.2 ; 210.1, 210.2 ; 310.1, 310.2).

3. Agencement selon la revendication 1 ou 2, dans lequel
- une première unité de soutien (110.1 ; 210.1 ; 310.1) de la paire d'unités de soutien est configurée pour exercer une première force de soutien,
- une deuxième unité de soutien (110.2 ; 210.2 ; 310.2) de la paire d'unités de soutien est configurée pour exercer une deuxième force de soutien, et
- le dispositif de couplage (112 ; 212 ; 312) est configuré de telle sorte que la grandeur de la première force de soutien s'écarte de la grandeur de la deuxième force de soutien de moins de 1,0 %, de préférence de moins de 0,5 %, de plus grande préférence de moins de 0,1 %.

4. Agencement selon l'une quelconque des revendications 1 à 3, dans lequel
- une première unité de soutien (110.1 ; 210.1 ; 310.1) de la paire d'unités de soutien présente une première unité de palier pneumatique (111.1) servant à générer une première force de soutien,
- une deuxième unité de soutien (110.2 ; 210.2 ; 310.2) de la paire d'unités de soutien présente une deuxième unité de palier pneumatique (111.2) servant à générer une deuxième force de soutien,
- le dispositif de couplage (112 ; 212 ; 312) présente une première unité de couplage (112.1 ; 212.1 ; 312.1) qui porte de manière mobile en translation la première unité de palier pneumatique (111.1) au moins le long de la première force de soutien,
- le dispositif de couplage (112 ; 212 ; 312) présente une deuxième unité de couplage (112.2 ; 212.2 ; 312.2) qui porte de manière mobile en translation la deuxième unité de palier pneumatique (111.2) au moins le long de la deuxième force de soutien, et
- la première unité de couplage (112.1 ; 212.1 ; 312.1) et la deuxième unité de couplage (112.2 ; 212.2 ; 312.2) sont couplées l'une à l'autre de telle sorte qu'une première translation de long de la première force de soutien sur la première unité de palier pneumatique (111.1) provoque une deuxième translation opposée le long de la deuxième force de soutien sur la deuxième unité de palier pneumatique (111.2),
dans lequel en particulier
- la grandeur de la première translation est au moins substantiellement égale à la grandeur de la deuxième translation,
et/ou
- l'unité de couplage (112.1, 112.2 ; 212.1, 212.2 ; 312.1, 312.2) respective est reliée par l'intermédiaire d'un palier pivotant (112.7, 112.8) à l'unité de palier pneumatique (111.1, 111.2) associée, dans lequel en particulier l'un des deux paliers pivotants (112.7, 112.8) limite exactement trois degrés de liberté en translation et l'autre des deux paliers pivotants (112.7, 112.8) limite exactement un degré de liberté en translation.

5. Agencement selon la revendication 4, dans lequel
- le dispositif de couplage est un dispositif de couplage hydraulique (112),
dans lequel en particulier
- la première unité de couplage (112.1) est une première unité piston/cylindre dotée d'un premier espace de travail hydraulique (112.3),
- la deuxième unité de couplage (112.2) est une deuxième unité piston/cylindre dotée d'un deuxième espace de travail hydraulique (112.4), et
- le premier espace de travail hydraulique (112.3) et le deuxième espace de travail hydraulique (112.4) sont couplés hydrauliquement l'un à l'autre,
dans lequel en particulier au moins l'un des points suivants s'applique :
- les deux unités piston/cylindre (112.1, 112.2) présentent une surface de piston effective au moins substantiellement identique,
- le premier espace de travail hydraulique (112.3) et le deuxième espace de travail hydraulique (112.4) sont couplés l'un à l'autre par au moins une conduite hydraulique (112.5),
- un dispositif d'étranglement (112.6) est prévu entre le premier et le deuxième espace de travail hydraulique (112.3, 112.4), l'étranglement étant en particulier réglable par le dispositif d'étranglement (112.6),
- le dispositif de couplage (112) comprend un dispositif de pompage servant au remplissage actif du premier et du deuxième espace de travail hydraulique (112.3, 112.4).

6. Agencement selon la revendication 4, dans lequel
- le dispositif de couplage est un dispositif de couplage (212) mécanique,
dans lequel en particulier
- la première unité de couplage (212.1) est un premier bras d'une unité à bascule (212.5),
- la deuxième unité de couplage (212.2) est un deuxième bras de l'unité à bascule (212.5), et
- le premier bras (212.1) et le deuxième bras (212.2) sont reliés au niveau d'un palier pivotant (212.9) de l'unité à bascule (212.5),
dans lequel en particulier au moins l'un des points suivants s'applique :
- le premier bras (212.1) et le deuxième bras (212.2) sont réalisés d'un seul tenant l'un avec l'autre,
- le palier pivotant (212.9) de l'unité à bascule (212.5) limite trois degrés de liberté en translation et deux degrés de liberté en rotation,
- le palier pivotant (212.9) de l'unité à bascule (212.5) est disposé au niveau d'une ligne de jonction des paliers pivotants (112.7, 112.8) des unités de couplage (212.1, 212.2), dans lequel en particulier un axe de pivotement du palier pivotant (212.9) de l'unité à bascule (212.5) intersecte la ligne de jonction,
- l'unité à bascule (212.5) comprend un dispositif d'amortissement (212.6) servant à amortir le pivotement autour du palier pivotant (212.9) de l'unité à bascule (212.5), la valeur d'amortissement du dispositif d'amortissement (212.6) étant en particulier réglable.

7. Agencement selon la revendication 4, dans lequel
- le dispositif de couplage est un dispositif de couplage actif (312),
dans lequel en particulier
- la première unité de couplage (312.1) comprend une première unité d'actionneur qui est reliée à un dispositif de commande (312.10),
- la deuxième unité de couplage (312.2) comprend une deuxième unité d'actionneur qui est reliée au dispositif de commande (312.10), et
- le dispositif de commande (312.10) pilote la première et la deuxième unité d'actionneur (312.1, 312.2) pour régler la première et la deuxième force de soutien,
dans lequel en particulier au moins l'un des points suivants s'applique :
- la première unité d'actionneur (312.1) et la deuxième unité d'actionneur (312.2) comprennent respectivement un actionneur dynamique piloté par le dispositif de commande (312.10),
- la structure de soutien (309) comprend un dispositif d'amortissement (312.6) servant à amortir les mouvements de l'unité optique (106, 107) générés par les unités d'actionneur (312.1, 312.2), la valeur d'amortissement du dispositif d'amortissement (312.6) étant en particulier réglable et/ou le dispositif d'amortissement (312.6) pouvant en particulier être relié à l'unité optique (106, 107),
- le dispositif de commande (312.10) commande les unités d'actionneur (312.1, 312.2) en utilisant un paramètre d'amortissement pour amortir les mouvements de l'unité optique (106, 107) générés par les unités d'actionneur (312.1, 312.2), le paramètre d'amortissement étant en particulier réglable.

8. Agencement selon la revendication 7, dans lequel
- le dispositif de commande (312.10) est relié à une première unité de détection (312.11) qui est configurée pour détecter au moins une première valeur de détection associée à la première unité de couplage (312.1),
- le dispositif de commande (312.10) est relié à une deuxième unité de détection (312.12) qui est configurée pour détecter au moins une deuxième valeur de détection associée à la deuxième unité de couplage (312.2),
- la valeur de détection respective est représentative d'une position de l'unité de couplage associée (312.1, 312.2) le long de la direction de la force de soutien associée et/ou d'une grandeur de la force de soutien associée et/ou d'un entrefer de l'unité de palier pneumatique associée (111.1, 111.2),
- le dispositif de commande (312.10) est configuré pour piloter la première et la deuxième unité d'actionneur (312.1, 312.2) en fonction de la première et de la deuxième valeur de détection.

9. Agencement selon l'une quelconque des revendications 1 à 8, dans lequel
- l'unité optique (106, 107) présente un centre de gravité,
- le poids de l'unité optique (106, 107) et les forces de soutien des unités de soutien (110.1, 110.2, 110.3, 110.4 ; 210.1, 210.2 ; 310.1, 310.2) intersectent un plan horizontal respectivement en un point d'intersection de force, et
- au moins l'unité de soutien (110.1 ; 210.1 ; 310.1) dont le point d'intersection de force dans le plan horizontal présente la plus petite distance par rapport au point d'intersection de force du poids forme l'une des deux unités de soutien (110.1, 110.2 ; 210.1, 210.2 ; 310.1, 310.2) de ladite au moins une paire d'unités de soutien,
dans lequel en particulier
- l'unité de soutien (110.2 ; 210.2 ; 310.2) dont le point d'intersection de force dans le plan horizontal présente la deuxième petite distance par rapport au point d'intersection de force du poids forme l'autre des deux unités de soutien (110.1, 110.2 ; 210.1, 210.2 ; 310.1, 310.2) de ladite au moins une paire d'unités de soutien,
et/ou
- l'unité optique (106, 107) définit dans le plan horizontal une direction circonférentielle, et les points d'intersection de force des deux unités de soutien (110.1, 110.2 ; 210.1, 210.2 ; 310.1, 310.2) de ladite au moins une paire d'unités de soutien sont directement voisins l'un de l'autre dans la direction circonférentielle.

10. Agencement selon l'une quelconque des revendications 1 à 9, dans lequel
- le nombre des unités de soutien (110.1, 110.2, 110.3, 110.4 ; 210.1, 210.2 ; 310.1, 310.2) est exactement égal à quatre,
ou
- le nombre des unités de soutien (110.1, 110.2, 110.3, 110.4 ; 210.1, 210.2 ; 310.1, 310.2) est au moins égal à cinq, en particulier exactement égal à cinq, et une autre paire d'unités de soutien, séparée de la paire d'unités de soutien, est prévue,
ou
- le nombre des unités de soutien (110.1, 110.2, 110.3, 110.4 ; 210.1, 210.2 ; 310.1, 310.2) est exactement égal à six, et deux autres paires d'unités de soutien, séparées de la paire d'unités de soutien et l'une de l'autre, sont prévues.

11. Dispositif d'imagerie optique, en particulier pour la microlithographie, comprenant
- un dispositif d'éclairage (102) doté d'un premier groupe d'éléments optiques (106),
- un dispositif d'objet (104) servant à recevoir un objet (104.1),
- un dispositif de projection (103) doté d'un deuxième groupe d'éléments optiques (107), et
- un dispositif d'image (105), dans lequel
- le dispositif d'éclairage (102) est réalisé pour éclairer l'objet (104.1), et
- le dispositif de projection (103) est réalisé pour projeter une représentation de l'objet (103.1) sur le dispositif d'image (105),
**caractérisé en ce que**
- le dispositif d'éclairage (102) et/ou le dispositif de projection (103) comprend/comprennent au moins un agencement selon l'une quelconque des revendications 1 à 10.

12. Procédé permettant de soutenir une unité optique (106, 107) pour la microlithographie, en particulier en utilisant de la lumière dans le domaine ultraviolet extrême (EUV) au moyen d'une structure de soutien (109 ; 209 ; 309), dans lequel
- l'unité optique (106, 107) est soutenue au moyen d'un nombre d'unités de soutien séparées (110.1, 110.2, 110.3, 110.4 ; 210.1, 210.2 ; 310.1, 310.2) de la structure de soutien (109 ; 209 ; 309) en ce que chacune des unités de soutien (110.1, 110.2, 110.3, 110.4 ; 210.1, 210.2 ; 310.1, 310.2) génère par l'intermédiaire d'une unité de palier pneumatique (111.1, 111.2, 111.3, 111.4) une force de soutien qui s'oppose au poids de l'unité optique (106, 107), la masse de l'unité optique (106, 107) allant en particulier de 4 t à 14 t, de préférence de 5 t à 10 t, de plus grande préférence de 6 t à 8 t,
- le nombre des unités de soutien (110.1, 110.2, 110.3, 110.4 ; 210.1, 210.2 ; 310.1, 310.2) s'élève au moins à quatre,
**caractérisé en ce que**
- au moins deux des unités de soutien (110.1, 110.2, 110.3, 110.4 ; 210.1, 210.2 ; 310.1, 310.2) sont couplées par l'intermédiaire d'un dispositif de couplage (112; 212 ; 312) en une paire d'unités de soutien de telle sorte que le dispositif de couplage (112; 212; 312) s'oppose à un écart d'un rapport prédéfinissable des deux forces de soutien des deux unités de soutien (110.1, 110.2 ; 210.1, 210.2 ; 310.1, 310.2) de la paire d'unités de soutien.

13. Procédé selon la revendication 12, dans lequel au moins l'un des points suivants s'applique :
- le rapport prédéfinissable des forces de soutien va de 1/3 à 1/1, de préférence de 1/2 à 1/1, de plus grande préférence de 2/3 à 1/1,
- le dispositif de couplage (112 ; 212; 312) égalise au moins substantiellement la grandeur des forces de soutien des deux unités de soutien (110.1, 110.2 ; 210.1, 210.2 ; 310.1, 310.2) de la paire d'unités de soutien,
- le dispositif de couplage (112 ; 212 ; 312) minimise un écart entre les grandeurs des forces de soutien des deux unités de soutien (110.1, 110.2 ; 210.1, 210.2 ; 310.1, 310.2),
- une première unité de soutien (110.1 ; 210.1 ; 310.1) de la paire d'unités de soutien exerce une première force de soutien, une deuxième unité de soutien (110.2 ; 210.2 ; 310.2) de la paire d'unités de soutien exerce une deuxième force de soutien, et la première force de soutien et la deuxième force de soutien sont réglées par le dispositif de couplage (112 ; 212 ; 312) de telle sorte que la grandeur de la première force de soutien s'écarte de la grandeur de la deuxième force de soutien de moins de 1,0 %, de préférence de moins de 0,5 %, de plus grande préférence de moins de 0,1 % (106, 107).

14. Procédé selon l'une quelconque des revendications 12 à 13, dans lequel
- une première unité de soutien (110.1 ; 210.1 ; 310.1) de la paire d'unités de soutien présente une première unité de palier pneumatique (111.1) servant à générer une première force de soutien,
- une deuxième unité de soutien (110.2 ; 210.2 ; 310.2) de la paire d'unités de soutien présente une deuxième unité de palier pneumatique (111.2) servant à générer une deuxième force de soutien,
- le dispositif de couplage (112 ; 212; 312) présente une première unité de couplage (112.1 ; 212.1 ; 312.1) qui porte de manière mobile en translation la première unité de palier pneumatique (111.1) au moins le long de la première force de soutien,
- le dispositif de couplage (112; 212; 312) présente une deuxième unité de couplage qui porte de manière mobile en translation la deuxième unité de palier pneumatique (111.2) au moins le long de la deuxième force de soutien, et
- la première unité de couplage (112.1 ; 212.1 ; 312.1) et la deuxième unité de couplage sont couplées l'une à l'autre de telle sorte qu'une première translation le long de la première force de soutien sur la première unité de palier pneumatique (111.1) provoque une deuxième translation opposée le long de la deuxième force de soutien sur la deuxième unité de palier pneumatique (111.2),
dans lequel en particulier au moins l'un des points suivants s'applique :
- la grandeur de la première translation est au moins substantiellement égale à la grandeur de la deuxième translation,
- l'unité de couplage (112.1, 112.2 ; 212.1, 212.2 ; 312.1, 312.2) respective est reliée par l'intermédiaire d'un palier pivotant (112.7, 112.8) à l'unité de palier pneumatique (111.1, 111.2) associée, dans lequel en particulier l'un des deux paliers pivotants (112.7, 112.8) limite exactement trois degrés de liberté en translation et l'autre des deux paliers pivotants (112.7, 112.8) limite exactement un degré de liberté en translation,
- la première unité de couplage (112.1) et la deuxième unité de couplage (112.2) sont couplées hydrauliquement,
- la première unité de couplage (212.1) et la deuxième unité de couplage (212.2) sont couplées mécaniquement, en particulier par l'intermédiaire d'une unité à bascule (212.5),
- la première unité de couplage (312.1) et la deuxième unité de couplage (312.2) sont couplées activement,
- un amortissement des mouvements de l'unité optique (106, 107) générés au moyen du dispositif de couplage (112; 212; 312) est effectué, la valeur d'amortissement de l'amortissement étant en particulier réglable,
- la première unité de couplage (312.1) comprend une première unité d'actionneur et la deuxième unité de couplage (312.2) comprend une deuxième unité d'actionneur, dans lequel
- au moins une première valeur de détection associée à la première unité de couplage (312.1) est détectée, au moins une deuxième valeur associée à la deuxième unité de couplage (312.2) est détectée, la valeur de détection respective est représentative d'une position de l'unité de couplage associée (312.1, 312.2) le long de la direction de la force de soutien associée et/ou d'une grandeur de la force de soutien associée et/ou d'un entrefer de l'unité de palier pneumatique associée (111.1, 111.2), la première et la deuxième unité d'actionneur (312.1, 312.2) sont pilotées en fonction de la première et de la deuxième valeur de détection.

15. Procédé d'imagerie optique, en particulier pour la microlithographie, dans lequel
- un dispositif d'éclairage (102) éclaire un objet (104.1) par un premier groupe d'éléments optiques (106), et
- au moyen d'un dispositif de projection (103) doté d'un deuxième groupe d'éléments optiques (107), une représentation de l'objet (104.1) est générée sur un dispositif d'image (105),
**caractérisé en ce que**
- dans le dispositif d'éclairage (102) et/ou le dispositif de projection (103), en particulier pendant la génération de la représentation, un procédé selon l'une quelconque des revendications 12 à 14 est utilisé.
